# EUROPÄISCHE PATENTSCHRIFT

(11) **EP 1 068 633 B1**
(45) Veröffentlichungstag und Bekanntmachung des Hinweises auf die Patenterteilung: **24.07.2002**
(21) Anmeldenummer: 99920585.9
(22) Anmeldetag: 01.04.1999
(51) Int. Cl.: H01J 37/32

(54) **VERFAHREN UND VORRICHTUNG ZUR GEZIELTEN TEILCHENMANIPULIERUNG UND -DEPOSITION**
METHOD AND DEVICE FOR SPECIFICALLY MANIPULATING AND DEPOSITING PARTICLES
PROCEDE ET DISPOSITIF POUR LA MANIPULATION ET LA SEDIMENTATION SPECIFIQUES DE PARTICULES

(30) Priorität: 02.04.1998 DE 19814871
(43) Veröffentlichungstag der Anmeldung: 17.01.2001
(73) Patentinhaber: Max-Planck-Gesellschaft zur Förderung der Wissenschaften e.V., 80539 München (DE); Kayser-Threde GmbH, 81379 München (DE)
(72) Erfinder: MORFILL, Gregor, D-81927 München (DE); THOMAS, Hubertus, D-85276 Pfaffenhofen (DE); STUFFLER, Timo, D-82290 Landsberied (DE); KONOPKA,Uwe, D-85375 Neufahrn (DE)
(74) Vertreter: Hertz, Oliver, Dr.
(86) Internationale Anmeldenummer: EP9902241
(87) Internationale Veröffentlichungsnummer: WO9952125

(56) Entgegenhaltungen:
- WO-A-98/44766
- PATENT ABSTRACTS OF JAPAN vol. 016, no. 349 (C-0967), 28. Juli 1992 (1992-07-28) & JP 04 103769 A (NEC CORP), 6. April 1992 (1992-04-06)

## Beschreibung

Die Erfindung betrifft ein Verfahren und eine Vorrichtung zur gezielten Manipulierung und/oder Deposition von mikroskopisch kleinen Teilchen in einem Hochfrequenzplasma.

Es ist allgemein bekannt, daß für Bearbeitungs- oder Abscheideverfahren wie z.B. das Plasmaätzen oder die chemische Dampfabscheidung (CVD) die Ausbildung eines Hochfrequenzplasmas im jeweiligen Reaktionsgas ein geeignetes Mittel zur Erzielung der gewünschten Degradationsreaktionen oder dgl. ist. Für die Optimierung von CVD-Anwendungen, z.B. zur Abscheidung von amorphem, hydrogeniertem Silizium (a-Si:H) für photovoltaische Einrichtungen, Dünnfilmtransistoren, Flachbildschirm-Anzeigen oder Farbdetektoren in Abbildungssystemen, gibt es zahlreiche Untersuchungen zur Abhängigkeit der Eigenschaften abgeschiedener Schichten von Plasmaparametern wie z.B. den Arten der Reaktionsgase, der HF-Spannung oder des Gasdrucks. Es hat sich gezeigt, daß sich im Plasma mikroskopisch kleine Teilchen (sogenannte Partikel) bilden können, die anwendungsabhängig störend oder fördernd auf die Schichteigenschaften einwirken.

So wird von D.M. Tanenbaum et al. in "Appl. Phys. Lett.", Band 69, 1996, Seite 1705 ff. die Ausbildung von Partikeln im Plasma bei der a-Si:H-Abscheidung wie folgt beschrieben: Im Reaktionsgas Silan werden durch Elektronenbeschuß negative Ionen gebildet, die im Plasma mit Radikalen und Kationen reagieren. Es entstehen wachsende Teilchen, die wegen der im Vergleich zu den Kationengeschwindigkeiten wesentlich höheren Elektronengeschwindigkeiten negativ geladen sind. Wegen der Ausbildung von Raumladungsgebieten in Elektrodennähe gelangen diese Teilchen, die bis zu einer Größe von µm-Dimensionen wachsen können, nicht zum Substrat, das in der Regel an einer der Elektroden angebracht ist. D.M. Tanenbaum et al. haben gezeigt, daß trotz der Raumladungszone Partikel im Größenbereich von rd. 2 bis 14 nm während der Plasmaentladung das Substrat erreichen und dort Störungen der Schichteigenschaften verursachen können.

Von P. Roca i Cabarrocas et al. wird in "14^{th} European Photovoltaic Solar Energy Conference" (Barcelona 1997), Paper No. P5A.20, eine wesentliche Verbesserung des Ladungsträgertransports in a-Si:H-Schichten durch Einbettung von Partikeln beschrieben. Die Partikel entstehen unter bestimmten Druckbedingungen im Reaktionsgas und werden durch charakteristische sogenannte "Hydrogen Evolution"-Messungen in der Schicht identifiziert. In den Partikel enthaltenden Schichten zeigt sich eine erhebliche Erhöhung der Dunkelleitfähigkeit und der Photoleitfähigkeit im Vergleich zu amorphen Schichten. Außerdem wurde eine erhebliche Verbesserung der Stabilität von photoelektrischen Eigenschaften bei Belichtung erhalten.

Ein generelles Problem bei den bisherigen Untersuchungen zur Wirkung von Partikeln in CVD-abgeschiedenen Schichten besteht darin, daß bisher ein Mittel zur gezielten und reproduzierbaren Handhabung der unregelmäßig im Reaktionsgas auftretenden Partikel nicht verfügbar ist. Dabei besteht insbesondere ein Problem darin, daß bei den üblichen Plasmafrequenzen von rd. 14 MHz die Partikel innerhalb rd. 1 Sekunde entstehen können.

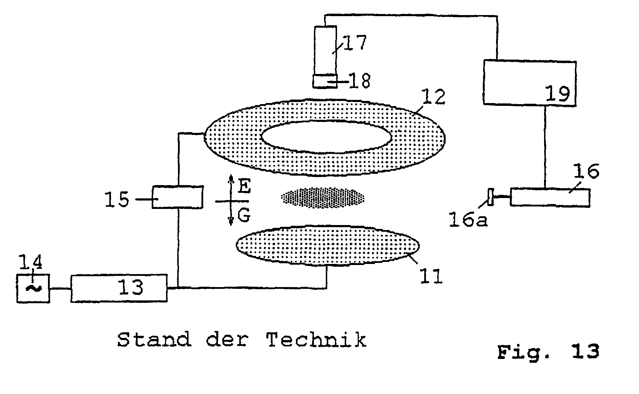

Weitere Gesichtspunkte der Partikelbildung werden im folgenden unter Bezug auf eine herkömmliche Anordnung gemäß Fig. 13 erläutert.

Ein Gas umfaßt im Plasmazustand, der beispielsweise durch eine Glimm- oder Gasentladung erzeugt wird, verschiedenartig geladene Teilchen, wie positiv oder negativ geladene Ionen, Elektronen und Radikale, aber auch neutrale Atome. Entstehen oder befinden sich im Plasma mikroskopische Teilchen (Größenordnung bis einige 10 µm), zum Beispiel Staubteilchen, so werden diese elektrisch aufgeladen. Die Ladung kann in Abhängigkeit von der Teilchengröße und den Plasmabedingungen (Gasart, Plasmadichte, Temperatur, Druck etc.) einige Hunderttausend Elektronenladungen erreichen.

In der bekannten Anordnung gemäß Fig. 13 sind in einem Reaktor (Gefäßwände nicht dargestellt) mit einem Trägergas zwei ebene Entladungselektroden übereinander angeordnet. Die untere kreis- oder scheibenförmige HF-Elektrode 11 wird mit einer Wechselspannung angesteuert, die obere, ringförmige Gegenelektrode 12 ist z. B. geerdet. Der Elektrodenabstand beträgt rd. 2 cm. Eine Steuerschaltung 13 ist dazu eingerichtet, den HF-Generator 14 mit der HF-Elektrode 11 zu verbinden und die Erdungs- und Trennschaltung 15 der Gegenelektrode 12 anzusteuern. Die Hochfrequenzenergie kann beispielsweise mit einer Frequenz von 13,56 MHz und einer Leistung von rd. 5 W eingekoppelt werden. Das Trägergas wird durch Edelgase oder reaktive Gase bei einem Druck von ca. 0.01 - 2 mbar gebildet.

Die Partikel ordnen sich vorzugsweise in einem Gleichgewichtszustand an, in dem die auf die Teilchen wirkende Gravitationskraft G mit einer elektrischen Feldkraft E ausgeglichen ist, die durch eine Raumladung in der Nähe der HF-Elektrode 11 auf die Teilchen in Abhängigkeit von deren Ladung ausgeübt wird. Es ist ferner die Bildung von plasmakristallinen Zuständen von Partikelanordnungen bekannt, was aber auf Teilchen mit charakteristischen Dimensionen oberhalb von 20 nm beschränkt ist, da für kleinere Partikel die jeweils getragene Ladung so gering ist, daß thermische Fluktuationen die Teilchen stärker beeinflussen als die für Plasmakristalle erforderlichen Coulomb-Wechselwirkungen, so daß eine regelmäßige Struktur nicht ausgebildet werden kann. Außerdem war die Ausbildung von Plasmakristallen bisher auf extern in den Reaktionsraum eingebrachte Teilchen wie z.B. Staubpartikel beschränkt. Eine gezielte Handhabung von nanokristallinen Partikeln, insbesondere mit charakteristischen Größen von wenigen bis einige 10 nm, konnte daher aus der Manipulierung von plasmakristallin angeordneten Teilchen nicht abgeleitet werden.

Mit Blick auf die an sich bekannte Beeinflussung struktureller oder photoelektrischer Eigenschaften abgeschiedener Schichten durch eingebaute nanokristalline Partikel besteht jedoch ein starkes Interesse daran, den Partikeleinbau insbesondere in Bezug auf die Art, die Größe, die Zahl und die Position der Partikel steuern zu können.

Aus der älteren nachveröffentlichten PCT-Anmeldung WO 98/44766 ist die Manipulierung von Partikeln im plasmakristallinen Zustand bekannt. In JP 04-103769 wird ein Laser-CVD-Verfahren beschrieben.

Die Aufgabe der Erfindung besteht darin, ein Verfahren zur gezielten Manipulierung oder Abscheidung (Deposition) von Teilchen in bzw. aus Plasmen, insbesondere zur Beeinflussung der Teilchen selbst oder zur Modifizierung einer Substratoberfläche oder einer Schicht, und eine Vorrichtung zur Realisierung des Verfahrens anzugeben.

Diese Aufgabe wird durch Verfahren mit den Merkmalen gemäß Patentanspruch 1 bzw. Vorrichtungen mit den Merkmalen gemäß Patentanspruch 13 gelöst. Vorteilhafte Ausführungsformen der Erfindung ergeben sich aus den abhängigen Patentansprüchen.

Die Erfindung beruht auf den folgenden Ideen. Teilchen, die im Reaktionsraum mit einem gezündeten Plasma intern entstehen oder in den Reaktionsraum von außen (extern) geliefert werden und zunächst negativ geladen sind, werden unter genügend energiereicher Bestrahlung, mit der insbesondere eine Ent- oder Umladung der Teilchen oder die Ausübung eines Lichtdruckes bewirkt wird, aus einer Ausgangsposition, die dem Kräftegleichgewicht des negativ geladenen Teilchen entspricht, in eine veränderte Zielposition bewegt. Die Teilchen können hierbei Partikel mit Teilchengrößen von einigen Nanometern bis rund 100 µm sein. Die energiereiche Bestrahlung kann eine Laserbestrahlung zur Bewirkung einer Entladung, eine UV-, Laser- oder Elektronenbestrahlung zur Partikelumladung durch Sekundärelektronenemission oder eine Lichtbestrahlung zur Erzeugung eines Lichtdruckes umfassen. Die Zielposition der Partikel kann ein Bereich mit veränderten Plasmabedingungen oder auch ein Substrat sein, auf dem die Partikel allein oder simultan mit einer Schichtbildung durch Plasmaabscheidung aufgetragen werden.

Die Nanopartikel sind im Plasma räumlich unregelmäßig verteilt. Dies bedeutet, daß sich die Nanopartikel relativ zueinander ungeordnet, an statistisch verteilten Orten befinden. Hierzu werden die Bedingungen im Reaktionsraum, insbesondere die Plasmabedingungen wie z.B. das Verhältnis von Elektronen zu Ionen im Plasma, partikelabhängig so eingestellt, daß die Partikel eine derart hohe Energie besitzen, daß keine geordneten oder plasmakristallinen Zustände gebildet werden.

Ein besonderer Vorteil der Erfindung besteht darin, daß die energiereiche Bestrahlung der zunächst räumlich unregelmäßig verteilten Partikel im Plasma ortsselektiv erfolgt, so daß Partikel in vorbestimmten, ausgewählten Plasmabereichen nach Art einer Maskierung veränderten Plasmabedingungen ausgesetzt oder entsprechend einem Depositionsmuster auf dem Substrat aufgetragen werden.

Das Gleichgewicht insbesondere zwischen der Gravitationskraft und elektrischen Kräften auf die Partikel in der Ausgangsposition kann ferner durch eine ortsabhängige Veränderung eines statischen oder niederfrequent veränderlichen elektrischen Feldes zwischen den Elektroden eines Plasmareaktors beeinflußt werden (Ausübung äußerer Verstellkräfte). Auf diese Weise lassen sich Teilchen im Plasma auf beliebig gekrümmten Flächen mit beliebigen Umrandungen anordnen. Die Teilchen im Plasma lassen sich somit in vorbestimmter Weise bewegen, wobei diese Bewegung sogar reversibel ist, so daß die Teilchenanordnung zwischen verschiedenen Konformationen umstellbar ist.

Ein weiterer wichtiger Gesichtspunkt der Erfindung besteht darin, daß durch die ortsselektive Deformation einer unregelmäßigen Partikelanordnung diese in verschiedenen Teilbereichen verschiedenen Plasmabedingungen ausgesetzt ist. Damit wird insbesondere in einem Plasma zwischen zwei im wesentlichen ebenen Elektroden eine ortsselektive Plasmabehandlung von Teilen der Partikel (z.B. Beschichtung oder Abtragung) möglich. Einer derartigen ortsselektiven Teilchenbehandlung kann sich eine Auftragung auf einem Substrat anschließen.

Ferner besteht ein wichtiger Gesichtspunkt der Erfindung darin, daß die Ausbildung einer Partikelanordnung durch die Anwesenheit eines Substrats in einem Plasmareaktor, insbesondere zwischen Reaktorelektroden zur Ausbildung einer Glimm- oder Gasentladung, unbeeinflußt ist. Es ist insbesondere möglich, die oben genannten Umstellvorgänge in unmittelbarer Nähe eines flächigen, ebenen oder gekrümmten Substrats durchzuführen und anschließend den Abstand zwischen den Teilchen der Partikelanordnung und der Substratoberfläche derart zu verringern, daß mindestens ein vorbestimmter Teil der Teilchen auf die Substratoberfläche aufgetragen werden. Die Abstandsverringerung kann entweder durch Beeinflussung der Feldkräfte, die die Teilchen in Position halten, oder durch Bewegung der Substratoberfläche erfolgen. Somit können die Teilchen in beliebig gestalteten Mustern auf Substratoberflächen abgeschieden werden. Damit stellt die Erfindung ein neuartiges ortsselektives, maskenfreies Beschichtungsverfahren bereit, mit dem modifizierte Oberflächen erzeugt werden. Aufgrund der aufgetragenen Teilchen besitzen die modifizierten Oberflächen veränderte elektronische, optische und/oder mechanische Eigenschaften. Es ist aber auch möglich, die ortsselektiv aufgetragenen Teilchen selbst zur Maskierung oder Konditionierung der Substratoberfläche vor oder während einem nachfolgenden weiteren Beschichtungsschritt zu verwenden.

Eine erfindungsgemäße Vorrichtung zur Manipulierung von Partikeln umfaßt ein Reaktionsgefäß, das Mittel zur Ausbildung eines Plasmas und mindestens ein Substrat enthält. Die Mittel zur Ausbildung des Plasmas werden vorzugsweise durch flächige, im wesentlichen parallele Elektroden gebildet, in deren Zwischenraum das Substrat beweglich ist. Die Elektroden im Reaktionsgefäß können feldformende Strukturen zur ortsselektiven Beeinflussung der Partikel aufweisen. Im Reaktionsgefäß können ferner Mittel zur ortsselektiven Teilchenentladung (z.B. UV-Belichtungsmittel mit einer Maskierungseinrichtung), Mittel zur Ausübung eines Strahlungsdruckes auf die Teilchen, Beobachtungsmittel und Steuermittel enthalten sein.

Ein besonderer Gesichtspunkt der Erfindung ist die Gestaltung der Elektroden zur ortsselektiven Beeinflussung der Teilchen im Reaktionsgefäß. Erfindungsgemäß wird eine Elektrodeneinrichtung (oder: adaptive Elektrode) angegeben, die eine Vielzahl von Elektrodensegmenten aufweist, die simultan mit einer Hochfrequenzspannung und jeweils einzeln mit einer segmentspezifischen Gleichspannung oder Niederfrequenzspannung beaufschlagt sind. Die Hochfrequenzspannung ist dazu eingerichtet, einen Plasmazustand im Reaktionsgefäß zu erzeugen bzw. aufrechtzuerhalten, während die Gleich- bzw. Niederfrequenzspannung dazu eingerichtet ist, im Reaktionsgefäß eine statische oder langsam veränderliche Feldverteilung (Feld E) zu erzeugen, unter deren Wirkung sich die Teilchen im Reaktionsgefäß anordnen oder bewegen. Weitere wichtige Merkmale der adaptiven Elektrode sind die Ausbildung einer aus miniaturisierten Elektrodensegmenten bestehenden Matrixanordnung, die Gestaltung der Matrixanordnung als im wesentlichen ebenes, schichtförmiges Bauteil, dessen Elektrodenseite zum Reaktionsgefäß hinweist und dessen Rückseite eine Steuerelektronik trägt, die Druckentlastung des Bauteils z. B. durch Ausbildung eines Unterdruckes in dem Raum, zu dem die Rückseite der Elektrodeneinrichtung weist, und die Bereitstellung einer Temperiereinrichtung für die Steuerelektronik.

Einzelheiten und Vorteile der Erfindung werden im folgenden unter Bezugnahme auf die beigefügten Zeichnungen beschrieben.
Es zeigen:
- Fig. 1: eine schematische Seitenansicht einer erfindungsgemäßen Anordnung zur Manipulierung von Partikeln;
- Fig. 2: eine schematische Draufsicht auf einen Teil der Anordnung gemäß Fig. 1;
- Fig. 3: eine schematische Illustration einer erfindungsgemäßen Elektrodengestaltung zur Manipulierung von Partikeln, und Beispiele einer ortsselektiven Substratbeschichtung;
- Fig. 4: eine Explosionsdarstellung eines mit einer erfindungsgemäßen adaptiven Elektrode versehenen Reaktionsgefäßes;
- Fig. 5: eine schematische Draufsicht auf eine adaptive Elektrode gemäß Fig. 4;
- Fig. 6: eine schematische Perspektivansicht einer Subeinheit der in den Figuren 4 und 5 dargestellten adaptiven Elektrode mit der zugehörigen Schaltelektronik;
- Fig. 7: eine Blockdarstellung zur Illustration der Steuerung einer erfindungsgemäßen adaptiven Elektrode;
- Fig. 8: eine schematische Illustration eines weiteren Beispiels einer ortsselektiven Substratbeschichtung;
- Fig. 9: eine Darstellung zur Illustration eines weiteren Beispiels einer ortsselektiven Substratbeschichtung;
- Fig. 10: eine schematische Draufsicht auf eine modifizierte Anordnung zur Manipulierung von Partikeln und ein weiteres Beispiel einer ortsselektiven Substratbeschichtung;
- Fig. 11: eine schematische Illustration einer Substratbeschichtung mit sogenannten Bucky Tubes;
- Fig. 12: eine schematische Draufsicht auf eine weitere Ausführungsform einer erfindungsgemäßen Anordnung zur Manipulierung von Partikeln; und
- Fig. 13: eine schematische Pespektivansicht eines herkömmlichen Reaktors (Stand der Technik).

Die Erfindung wird im folgenden am Beispiel einer Plasmaanordnung beschrieben, die als Reaktionsgefäß einen Reaktor umfaßt, dessen Aufbau in Bezug auf die Plasmaerzeugung und die Partikelbeobachtung im wesentlichen dem herkömmlichen Aufbau entspricht, wie er oben unter Bezug auf Fig. 13 beschrieben wurde. Es ist dem Fachmann jedoch verständlich, daß auch anders aufgebaute Reaktoren verwendet werden können, soweit sie zur erfindungsgemäßen Manipulierung von Teilchen in einer Partikelanordnung eingerichtet sind.

Die folgende Beschreibung bezieht sich auf zwei Ausführungsbeispiele, von denen das erste Ausführungsbeispiel die Manipulierung bzw. Deposition von extern in den Reaktionsgefäß eingeführten Partikeln und die zweite Ausführungsform die Manipulierung bzw. Deposition von intern im Reaktionsgefäß generierten Partikeln betrifft.

### Erste Ausführungsform

Die folgende Erläuterung bezieht sich auf die Manipulation von Partikeln, die aus Übersichtlichkeitsgründen als im wesentliche ebene Partikelanordnung dargestellt und mit den Bezugszeichen 10, 20, 40, 50, 60, 70 bezeichnet sind. Diese Partikelanordnungen sind allgemein unregelmäßig und können Mono- oder Mehrfachschichtungen umfassen. Die Nanopartikel besitzen vorzugsweise Größen im Bereich von wenigen Nanometern bis 10 nm, können aber auch größer sein, und werden im Reaktor gebildet oder von außen zugeführt.

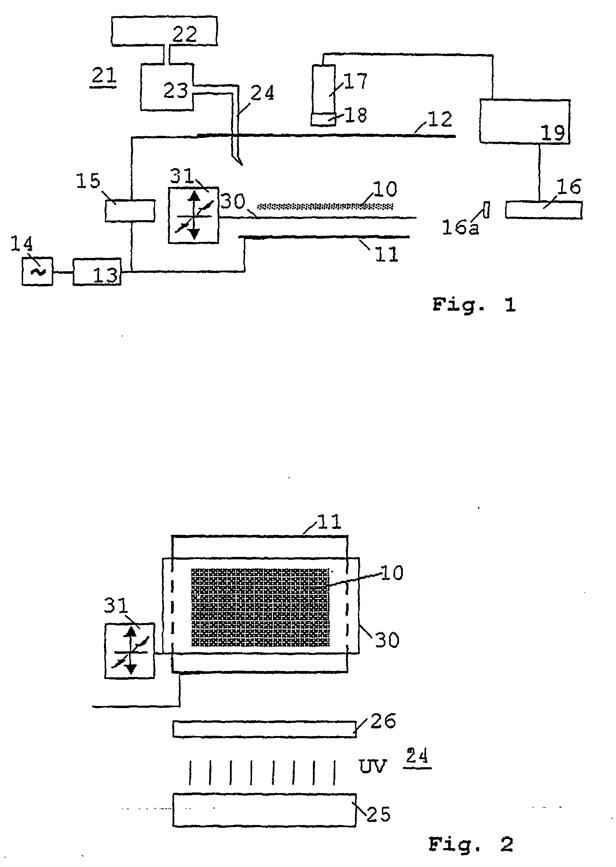

Die schematische Seitenansicht einer Anordnung zur Manipulierung von Partikeln gemäß Fig. 1 zeigt eine HF-Elektrode 11, eine geerdete Gegenelektrode 12, eine Steuereinrichtung 13, einen HF-Generator 14 und eine Schalteinrichtung 15. Eine Beobachtungslichtquelle 16 mit einer Zylinderlinsenanordnung 16a, ein Beobachtungsmittel in Form einer CCD-Kamera 17 mit einer Vergrößerungsoptik 18 und eine zugehörige Steuereinrichtung 19 stellen optische Beobachtungsmittel dar, deren Bereitstellung (insbesondere bei der zweiten Ausführungsform (s. unten) gegebenenfalls unterbleiben kann. So wird bei sehr kleinen (< 100 nm) Teilchen ein anderes Beobachtungsmittel erforderlich (z.B. unter Verwendung der Braggstreuung). Ein Staubdispensor 21 mit einem Reservoir 22, einer Konditionierungseinrichtung 23 und einem Einlaßmittel 24 ist dazu eingerichtet, Teilchen in den Raum zwischen der HF-Elektrode 11 und der Gegenelektrode 12 einzubringen. Die Konditionierungseinrichtung 23 kann beispielsweise eine Vorladungseinrichtung für die Teilchen enthalten.

Die erfindungsgemäße Anordnung umfaßt ferner ein Substrat 30, das mit einer Verstelleinrichtung 31 in alle Raumrichtungen beweglich ist. Figur 1 zeigt nicht die Wandung des Reaktionsgefässes, die einen geschlossenen Raum für das Trägergas bildet und vakuumdicht die Elektroden 11, 12, das Substrat 30 und Teile der Teilchenzuführeinrichtung einschließt. Die Wandung kann ferner Fenster zur Strahlungsein- bzw. -auskopplung aufweisen.

Figur 2 zeigt schematisch eine Draufsicht auf Teile der erfindungsgemäßen Anordnung gemäß Fig. 1, nämlich die HF-Elektrode 11 und das Substrat 30 mit der Verstelleinrichtung 31. Zusätzlich ist eine in Fig. 1 nicht gezeigte Entladeeinrichtung 24 dargestellt, die zur ortsselektiven Entladung von Partikeln eingerichtet ist. Beim dargestellten Beispiel umfaßt die Entladeeinrichtung 24 eine UV-Strahlenquelle 25 und ein geeignetes Abbildungs- und Maskierungssystem, mit z. B. eine Gruppe der Partikel bzw. Partikel in vorbestimmten Raumbereichen ortsselektiv bestrahlt und unter Wirkung der UV-Strahlung entladen werden können.

Die UV-Strahlenquelle 25 und das Abbildungs- und Maskierungssystem 26 können alternativ auch eine Umladeeinrichtung 24 darstellen. In diesem Fall ist die Leistung der UV-Strahlenquelle 25 derart gewählt, daß an den Partikeln bei UV-Beleuchtung Sekundärelektronenemissionen auftreten, in deren Ergebnis die Nettoladung des Partikels positiv ist. Anstelle der dargestellten Ausführungsform einer ausgedehnten UV-Strahlenquelle 25 kann auch eine eng begrenzte, intensive Lichtquelle z.B. in Form eines UV-Lasers vorgesehen sein, wobei dann das Abbildungs- und Maskierungssystem 26 zur rasterartigen, sequentiellen Beleuchtung der interessierenden Bereich der Partikelanordnung 10 eingerichtet ist. Die UV-Beleuchtung erfolgt in diesem Fall vorzugsweise von oben durch die Ringelektrode 12.

Ersatzweise kann zur Umladung das Bauteil 25 auch eine Elektronenquelle bezeichnen, wobei dann das Bauteil 26 ein Strahllenkungssystem darstellt. Mit dem Strahllenkungssystem wird ein Elektronenstrahl von der Elektronenquelle auf die interessierenden Bereiche der Partikelanordnung gerichtet, um die dort befindlichen Partikel mittels Sekundärelektronenemission umzuladen. Diese Einkopplung des Elektronenstrahls erfolgt ebenfalls vorzugsweise von oben durch die Ringelektrode 12.

Im folgenden wird eine erste Variante der erfindungsgemäßen Verfahrensweise zur Manipulierung der Teilchen im Plasma unter Bezug auf die Figuren 1 und 2 erläutert.

Im (nicht dargestellten) Reaktionsgefäß, insbesondere zwischen den HF- und Gegenelektroden, die als Entladungselektroden wirken, wird in einem Trägergas ein Plasma gezündet. Ein besonderer Vorteil bei der ersten Ausführungsform besteht darin, daß an die Art des Trägergases keine besonderen Anforderungen zu stellen sind. Die Plasmabedingungen (Art und Dichte des Gases, HF- Leistung, Frequenz, Druck etc.) können vom Fachmann entsprechend den Bedingungen der Partikelanordnung ausgewählt werden. Es können beispielsweise auch Niederenergie-Argonentladungen oder Silanentladungen unter den Bedingungen verwendet werden, wie sie bei der Plasmaabscheidung in der Halbleitertechnologie benutzt werden. Der Einsatz eines reaktiven Gases wie z.B. Silan ist für weitere Behandlungsschritte an den Partikeln von Vorteil. Die Energie der Ionen im Plasma entspricht im wesentlichen der Gastemperatur. Diese wird durch die Entladungsbedingungen und gegebenenfalls durch eine äußere Kühleinrichtung bestimmt. So kann beispielsweise in einer erfindungsgemäßen Anordnung eine (nicht dargestellte) Stickstoffkühlung vorgesehen sein.

Über den Staubdispensor 21 können die zu manipulierenden Teilchen in den Elektrodenraum eingebracht. Die Teilchengröße liegt im Bereich von einigen nm bis 100 µm. Die Untergrenze der Teilchengröße wird durch die Druckbedingungen im Reaktionsgefäß und über die Aufladung festgelegt. Die Teilchen sollten so schwer sein, daß im plasmafreien Zustand die Teilchen unter Wirkung der Schwerkraft eine vertikale Bewegung ausführen und nicht im Schwebezustand verbleiben. Die Obergrenze der Teilchengrößen wird durch die sogenannte Debye-Länge der Wechselwirkung zwischen benachbarten Teilchen festgelegt. Die Debye-Länge steigt proportional zur Wurzel der Plasmatemperatur bzw. umgekehrt proportional zur Wurzel der Plasmadichte. Ein weiterer besonderer Vorteil der Erfindung besteht darin, daß neben den Größenanforderungen an die zu manipulierenden Teilchen keine weiteren Einschränkungen in Bezug auf die Form oder das Material der Teilchen bestehen. Es sind beliebige, z.B. runde, nadelförmige, rohrförmige oder plättchenförmige Teilchen verwendbar. Die Teilchen müssen fest sein bzw. eine genügende Formstabilität unter den Plasmabedingungen besitzen. Es wird vorzugsweise ein Material verwendet, das im interessierenden Teilchengrößenbereich besondere elektrische oder optische Eigenschaften besitzt. Es kann auch ein Material verwendet werden, das eine Zusammensetzung aus verschiedenen Substanzen, z.B. organischen Stoffen, ist.

Die in das Plasma eingebrachten Teilchen bilden eine Partikelanordnung 10 (s. Figuren 1, 2). Diese kann eine beliebige, ungeordnete Teilchenanordnung sein.

Die HF-Elektrode 11 weist eine negative Gleichspannung auf. Bei einem Durchmesser der Elektroden von rd. 8 bis 10 cm, einem Elektrodenabstand von rd. 2 cm und einer Vorspannung an der HF-Elektrode 11 von rd. -15 Volt ordnen sich beispielsweise Polymerteilchen einer charakteristischen Größe von rd. 7 µm als flächige Wolke mit einem Abstand von rd. 0,5 cm von der HF-Elektrode 11 an.

Die hier beispielhaft gegebenen Systemdimensionen ändern sich bei veränderten Elektrodenparametern (Elektrodendurchmesser, Elektrodenabstand, Spannungswerte) entsprechend. Der Elektrodendurchmesser kann beispielsweise im Bereich von wenigen Zentimetern bis 60 cm und der Elektrodenabstand kann im Bereich von 1 cm bis 10 cm liegen. Es werden vorzugsweise solche Elektrodenparameter ausgewählt, die mit verfügbaren und CVD-Reaktoren kompatibel sind.

Das Substrat 30 ist zwischen der HF-Elektrode 11 und der Partikelanordnung 10 angeordnet. Auch in Bezug auf das Substratmaterial und die Substratform bestehen vorteilhafterweise keine Beschränkungen. Es kann insbesondere sowohl ein leitfähiges als auch ein nicht-leitfähiges Substrat verwendet werden, ohne daß die Bedingungen für die Partikelanordnung sich verändern.

Bei einem erfindungsgemäßen Verfahren zur Manipulierung von Teilchen erfolgt zunächst eine Einstellung der Teilchen in einer Ausgangs- oder Behandlungsposition. Diese Behandlungsposition kann einem Kräftegleichgewichtszustand nach Einführung der Teilchen in den Reaktor entsprechen. Es ist aber auch möglich, die Partikelanordnung 10 zu bewegen, insbesondere die Relativposition in Bezug auf die Elektroden oder das Substrat zu ändern. Dies erfolgt beispielsweise durch eine Änderung der Plasma- oder Feldbedingungen. So kann durch eine Änderung der Trägergasdichte eine Änderung der Teilchenladung und somit eine Änderung des Gleichgewichtszustands zwischen Gravitationskraft und elektrischer Kraft erzielt werden. Entsprechendes gilt bei Änderung der negativen Vorspannung der HF-Elektrode oder bei einer äußeren Entladung der Teilchen. In der Behandlungsposition wird in einem nächsten Schritt mindestens ein Teil der Teilchen einer Plasmabehandlung oder einer Auftragung auf das Substrat unterzogen.

Die Plasmabehandlung kann beispielsweise eine Teilchenoberflächen-Beschichtung oder -Abtragung umfassen. Im letzteren Fall kann beispielsweise ein schrittweises Absenken der Partikelanordnung zu einem geringeren Abstand von der HF-Elektrode dazu führen, daß die untersten Schichten der Partikelanordnung einem selektiven Plasmaätzprozeß unterzogen werden. Zur Teilchenbeschichtung kann ggf. ein Plasmawechsel bei laufendem Reaktorbetrieb vorgesehen sein.

Zur Auftragung auf dem Substrat 30 kann jede geeignete Änderung des Abstands zwischen den Partikelanordnungen und der Substratoberfläche verwendet werden. Gemäß einer ersten Alternative werden die Partikelanordnungen durch Änderung der Plasmabedingungen bzw. durch eine gezielte, ortsselektive Entladung auf das Substrat gesenkt. Gemäß einer zweiten Alternative kann das Substrat mit der Verstelleinrichtung 31 zur Partikelanordnung angehoben werden. Gemäß einer dritten, bevorzugten Alternative wird die Entladung zwischen den Elektroden abgeschaltet, so daß das Plasma erlischt und die Teilchen auf das Substrat fallen. Beim Kontakt zwischen den Teilchen und dem Substrat führen molekulare Anziehungskräfte zur Adsorption der Teilchen an der Substratoberfläche. Gleichzeitig oder im weiteren Verfahren kann die Teilchenadsorption durch eine Überschichtung noch verstärkt werden.

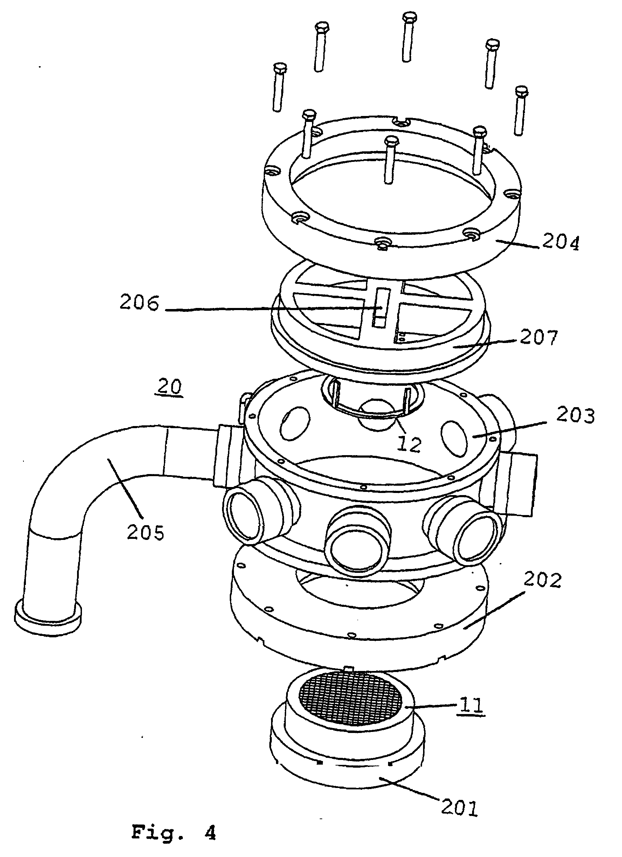

Fig. 3 zeigt eine schematische Seitenansicht eines Ausschnitts einer erfindungsgemäßen Anordnung zur Teilchenmanipulierung. Zwischen der HF-Elektrode 11 und dem Substrat 30 mit der Verstelleinrichtung 31 einerseits und der geerdeten Gegenelektrode 12 sind Partikelanordnungen angeordnet. Die Partikelanordnung 40 ist mit einer mehrfach gewölbten Querschnittsform ausgebildet, die im wesentlichen dem Verlauf des statischen elektrischen Feldes im Raum zwischen den Elektroden entspricht. Das Feld zwischen den Elektroden wird durch eine Elektrodenstrukturierung 41 ortsselektiv verformt. Beim dargestellten Beispiel wird die Elektrodenstrukturierung durch Zusatzelektroden 41 (Nadel-Elektroden) gebildet, die mit einer positiven Spannung beaufschlagt und isoliert durch die Gegenelektrode 12 durchgeführt sind. Die Partikelanordnung folgt der ortsselektiven Deformierung des elektrischen Feldes, so daß ein mehrfach gewölbtes Gebilde entsteht. Die Zusatzelektroden 41 können reihenweise oder flächig angeordnet sein. Statt einem positiven Potential können die Zusatzelektroden 41 auch mit einem negativen Potential beaufschlagt sein.

Im unteren Teil von Fig. 3 sind zwei Beispiele einer ortsselektiven Substratbeschichtung mit erfindungsgemäß manipulierten Partikelanordnungen schematisch gezeigt. Erfolgt eine Formation der Partikelanordnung derart, daß die Querschnittsform nach oben weisende Auswölbungen zeigt, so führt eine Annäherung der Partikelanordnungen an das Substrat 30 gemäß der oben genannten ersten oder zweiten Alternative zu einem Beschichtungsmuster entsprechend dem unteren, linken Teil von Fig. 3. Wird umgekehrt eine nach unten weisende Auswölbung (durch negative Potentiale der Zusatzelektroden 41) eingestellt, so führt die gegenseitige Annäherung zu einer inselförmigen Beschichtung gemäß dem unteren, rechten Teil von Fig. 3.

Durch eine geeignete Formung der Elektrodenstrukturierung oder der Zusatzelektroden lassen sich beliebige Beschichtungsmuster z.B. in Form von Kreisen, Ringen, Bögen, Streifen oder dgl. auf der Substratoberfläche ausbilden. Zusätzliche Modifizierungen sind möglich, wenn die Zusatzelektroden gemäß Fig. 3 beweglich angeordnet sind, so daß die Manipulierung der Partikel 40 im Zeitverlauf variiert werden kann. Dementsprechend lassen sich verschiedene Beschichtungsmuster aufeinanderfolgend auf dem Substrat 30 auftragen.

Eine alternative Gestaltung zur ortsselektiven Verformung des Feldes zwischen den Elektroden wird im folgenden unter Bezug auf die Figuren 4 bis 7 erläutert.

Fig. 4 zeigt eine Explosionsdarstellung eines Reaktionsgefäßes 20, das zur Realisierung der Erfindung eingerichtet ist. Das Reaktionsgefäß 20 ist nicht nur an die im folgenden erläuterte adaptive Elektrode angepaßt, sondern kann auch in Verbindung mit den in den anderen Figuren dargestellten Ausführungsformen der Erfindung realisiert werden. Das Reaktionsgefäß 20 besteht aus einer Elektrodenaufnahme 201, die in den Rezipientenboden 202 eingelassen ist. Der Reaktionsraum wird vom Rezipientenboden 202 mit der Elektrodenaufnahme 201, der Rezipientenwand 203 und dem Rezipientendeckel 204 eingeschlossen und ist über den Vakuumanschluß 205 evakuierbar. Der Rezipientendeckel 204 besitzt einen Fenstereinsatz 206, der auf einer gegebenenfalls gegenüber dem Rezipientendeckel 204 vakuumdicht verdrehbaren Subeinheit 207 des Rezipientendeckels 204 angebracht ist. Es kann vorgesehen sein, daß die Subeinheit 207 selbst unter Vakuum verdrehbar ist. Der Fenstereinsatz 206 ist zur Aufnahme unterschiedlicher Beobachtungs- oder Diagnosemittel für die im Reaktionsraum manipulierten Teilchen ausgelegt. Die Teile des Reaktionsgefäßes 20 sind in üblicher Weise wie bei einem Vakuumgefäß verbunden. Des weiteren können über seitliche Flanscheinheiten zusätzlich unterschiedliche Diagnostikeinheiten eingebracht werden.

In Fig. 4 sind ferner die adaptive HF-Elektrode 11 und die geerdete Gegenelektrode 12 (vgl. Fig. 1) gezeigt. Die Gegenelektrode 12 ist ringförmig ausgebildet, um eine Beobachtungsöffnung für das Beobachtungsmittel (nicht dargestellt) zu bilden.

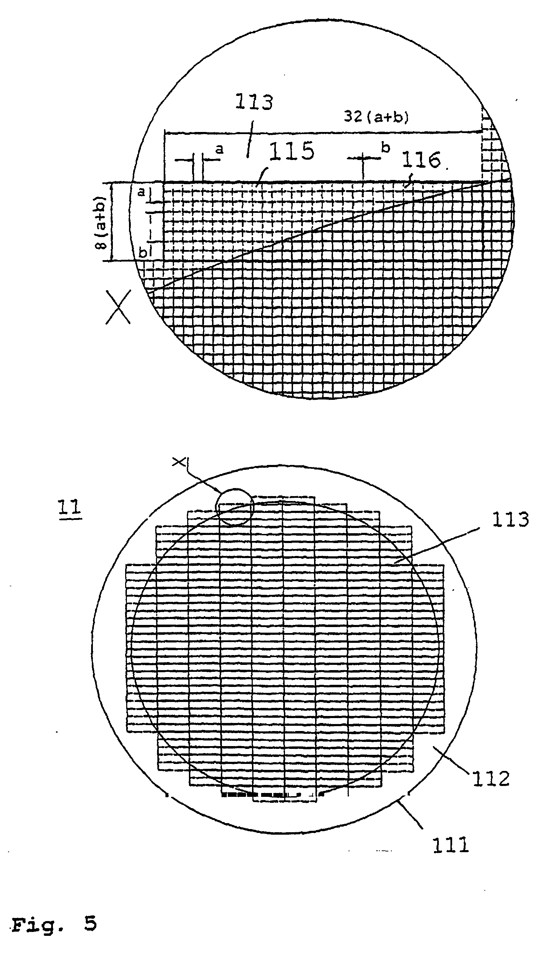

Eine vergrößerte Draufsicht auf die adaptive Elektrode 11 ist in Fig. 5 dargestellt. Die adaptive Elektrode 11 besitzt entsprechend der üblichen zylinderförmigen Gestaltung von Vakuumgefäßen zur Bildung eines durch äußere Rezipienteneinbauten möglichst ungestörten Feldverlaufs eine im wesentlichen kreisrunde Umrandung 111. Innerhalb der Umrandung befinden sich eine Ringelektrode 112 und eine Vielzahl Elektrodensegmenten, die beim dargestellten Beispiel in Elektrodensubeinheiten 113 zusammengefaßt sind. Die Ringelektrode 112 ist als einstückiger, durchgehender Elektrodenbereich dargestellt und zur Feldkorrektur (Abflachung) des elektrischen Feldes des hochsegmentierten Elektrodenbereiches eingerichtet. Es ist jedoch ersatzweise auch möglich, anstelle der Ringelektrode 112 einen segmentierten Elektrodenbereich vorzusehen, in dem jedoch die Segmente mit identischen Feldern beaufschlagt werden. Im Übergangsbereich zwischen den Elektrodensubeinheiten und der Ringelektrode werden die Subeinheiten derart in der Höhe verändert, daß der Ring (eventuell von der Unterseite ausgefräst) über die Subeinheiten geschoben werden kann.

Die Elektrodensubeinheiten 113 sind in einem inneren, von der Ringelektrode 112 umgebenen Bereich der Elektrode 11 vorgesehen und umfassen jeweils eine Vielzahl von Elektrodensegmenten. Die Form, Größe und Zahl der Elektrodensegmenten wird anwendungsabhängig je nach den räumlichen Anforderungen an ein elektrisches Gleich- oder Niederfrequenzfeld (E) zwischen den Elektroden 11, 12 (vgl. Fig. 1) konstruiert. Die größte Variabilität der einstellbaren Feldverläufe wird durch eine Matrixanordnung einer Vielzahl von punktförmigen Elektrodensegmenten (im folgenden als Punktsegmente oder Punktelektroden bezeichnet) erreicht. Hierbei bedeutet die Bezeichnung punktförmiges Elektrodensegment bzw. Punktsegment, daß zwar jedes Elektrodenelement eine zum Reaktionsraum hinweisende endliche Fläche besitzt, diese jedoch wesentlich kleinere Dimensionen als die Gesamtgröße der Elektrode 11 besitzt. So besitzt jede Punktelektrode beispielsweise eine charakteristische Längen-Dimension, die um einen Faktor von rund 1/500 bis 1/100, z.B. 1/300, gegenüber der Außendimension (Durchmesser) der Elektrode 11 verkleinert ist. Das Matrixraster kann jedoch anwendungsabhängig auch größer gewählt werden. Bei der hier dargestellten Punktrasterform der adaptiven Elektrode ist eine charakteristische Längen-Dimension der Punktelektrode vorzugsweise gleich oder kleiner der Debye-Länge der Teilchen im Plasma (z. B. rund 3 mm).

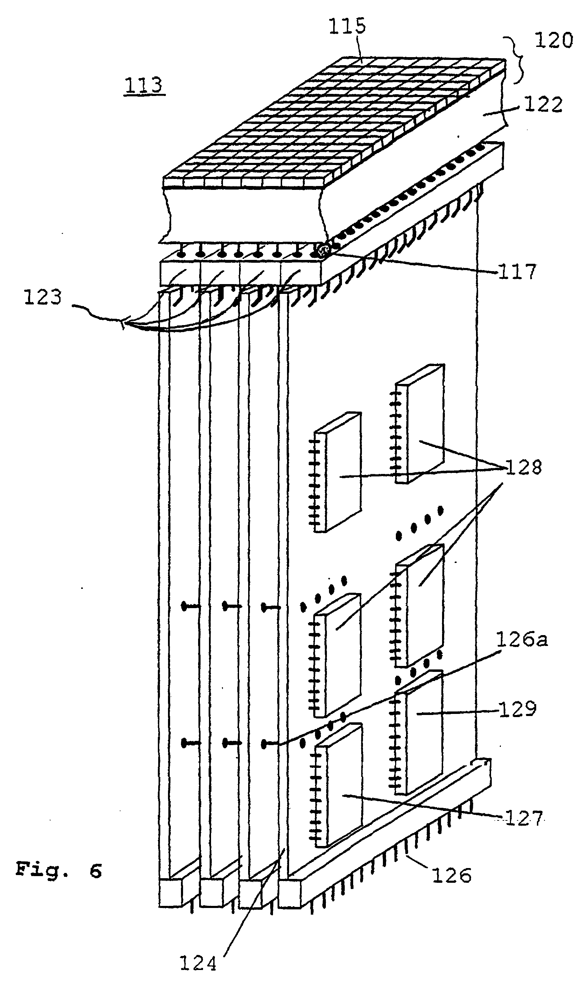

Eine adaptive Elektrode 11 besitzt beispielsweise einen Außendurchmesser von rund 50 cm mit einer Breite der Ringelektrode 112 von rund 5 cm, so daß der innere Bereich der Elektrodensegmente 113 einen Durchmesser von rund 40 cm besitzt. Die adaptiven Elektrodensubeinheiten 113 können in ihrer Gesamtheit beispielsweise rund 50.000 bis 100.000 Punktsegmente umfassen. Ein bevorzugtes Maß der Segmentierung ist ein 1.27-mm-Raster, das mit verfügbaren 1/20-Zoll-Steckereinrichtungen kompatibel ist, wie dies unten unter Bezug auf Fig. 6 näher erläutert wird. In diesem Fall lassen sich innerhalb der Ringelektrode 112 rund 80.000 voneinander elektrisch isolierte Punktsegmente anordnen.

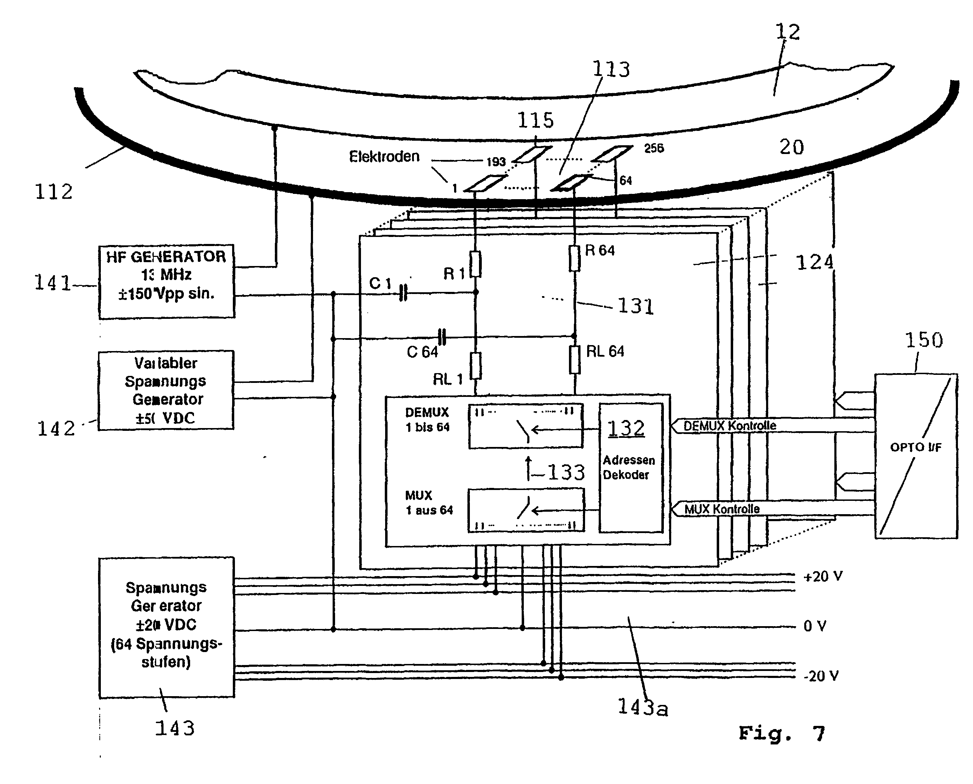

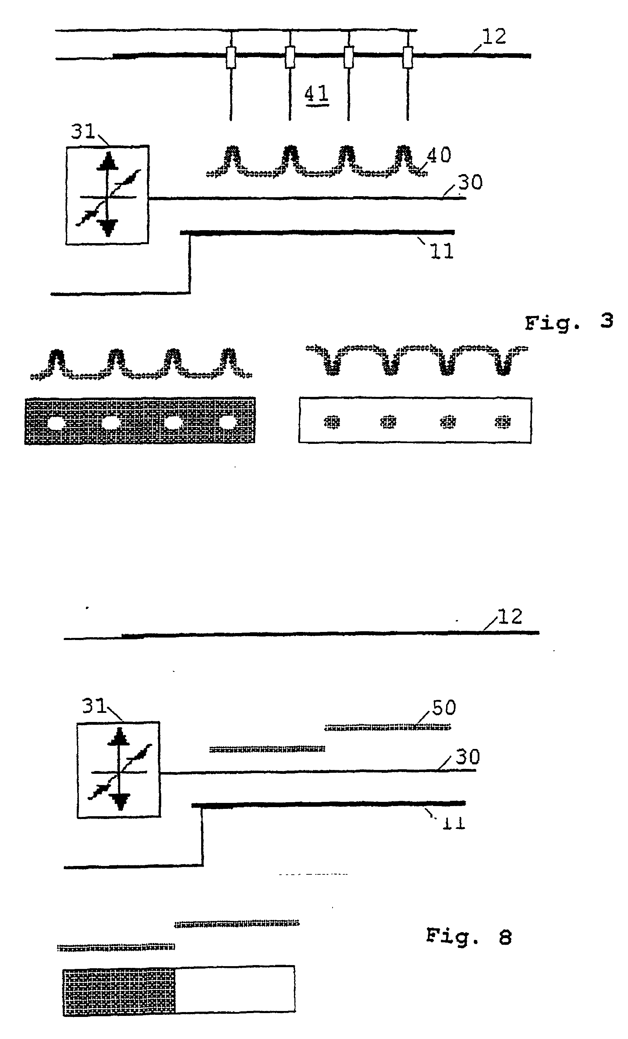

Aus Übersichtlichkeitsgründen zeigt der untere Teil von Fig. 5 nicht jedes einzelne Punktsegment, sondern die Elektrodensubeinheiten (Punktsegmentgruppen). Die gruppenweise Zusammenfassung von Punktsegmenten ist kein zwingendes Merkmal der Erfindung, besitzt jedoch Vorteile bei der Elektrodenansteuerung, wie dies unten im einzelnen unter Bezug auf die Figuren 7 und 8 erläutert wird. So zeigt das Linienmuster im unteren Teil von Fig. 5 beispielsweise Elektrodensubeinheiten 113, die jeweils 8 · 32 Punktsegmente enthalten. Dies wird durch den oberen Teil von Fig. 5 verdeutlicht, der eine Ausschnittsvergrößerung (X) vom Rand der Elektrodensubeinheiten 113 darstellt. Die Erfindung ist nicht auf die Zusammenfassung von 8 · 32 Punktsegmenten zu einer Elektrodensubeinheit beschränkt, sondern kann konstruktions- und anwendungsabhängig andere Gruppierungen umfassen (z. B. 16 · 16 Punktsegmente).

Der obere Teil von Fig. 5 zeigt beispielhaft hervorgehoben eine Elektrodensubeinheit 113 mit einer Vielzahl von Punktsegmenten oder Punktelektroden 115, die jeweils untereinander durch Isolationsstege voneinander elektrisch getrennt sind. Die Punktelektroden 115 besitzen zum Reaktionsraum weisende, quadratische Stirnflächen der Breite a = 1.25 mm. Die Isolationsstege 116 besitzen eine Breite b = 0.02 mm, so daß sich insgesamt das oben genannte 1.27 mm-Raster ergibt. Die Elektrodensubeinheit 113 umfaßt z.B. 8 · 32 Punktelektroden 115. Aus Fig. 5 ist ferner ersichtlich, daß sich die Ringelektrode 112 und der Bereich der Elektrodensubeinheiten 113 gegenseitig überlappen. Damit wird eine optimale, dichte Ausfüllung des inneren Bereiches der Elektrode 11 auch am Rand der Ringelektrode 112 erzielt, wie dies im vergrößerten Teil von Fig. 5 erkennbar ist.

Sowohl die Ringelektrode 112 als auch die Elektrodensubeinheiten 113 bestehen aus einem metallischen Elektrodenwerkstoff. Das Material wird anwendungsabhängig und je nach dem gewünschten Herstellungsverfahren für die Elektrode gewählt. Bei den unten erläuterten Ätzverfahren kann als Elektrodenwerkstoff z.B. Edelstahl, Aluminium oder Kupfer verwendet werden. Zur Vermeidung von elektrischen Störungen durch Abscheidungen auf der Elektrodenfläche wird diese vorzugsweise mit einer Isolationsschicht überzogen, die z.B. aus demselben Isolationsmaterial wie die Isolationsstege 116 besteht. Die Isolationsschicht kann beispielsweise eine Dicke von rund 10 µm bis 100 µm, vorzugsweise 20 µm, besitzen. Als Isolationsmaterial der Isolationsstege 116 ist jedes Material geeignet, das bei den auftretenden Spannungswerten eine genügende Isolationsfestigkeit zwischen den Punktelektroden gewährt. Dieses Isolationsmaterial ist beispielsweise Epoxydharz oder ein anderer geeigneter Kunststoff.

Fig. 6 zeigt den Aufbau der segmentierten Elektrode am Beispiel einer Elektrodensubeinheit 113. Entsprechend dem oben erläuterten Beispiel umfaßt die Elektrodensubeinheit 113 wiederum beispielhaft 8 · 32 Punktelektroden 115. Diese bilden (gemeinsam mit den übrigen , nicht dargestellten Segmenten der adaptiven Elektrode) einen oberen Elektrodenbereich, der auch als segmentierte Elektrode 120 bezeichnet wird. Die segmentierte Elektrode besteht des weiteren aus der Isolationsplatte 122, in die eine Vielzahl von Buchsen eingearbeitet sind (nicht dargestellt), deren Zahl und Anordnung jeweils den Punktelektroden 115 der Elektrodensubeinheit 113 entspricht. Die Buchsen sind zur Aufnahme von Steckereinheiten 123 eingerichtet, die gegebenenfalls auch als integrale Basisplatte ausgebildet sein können. Es besteht auch die Möglichkeit, die Steckereinheiten 123 als Buchsen auszulegen und eine elektrische Verbindung mit den Buchsen, welche in die Isolationsplatte integriert sind, über leitfähige Stifte herzustellen. Zwischen jeder Buchse der Isolationsplatte 122 und der entsprechenden Punktelektrode 115 besteht ein elektrischer Kontakt. Der Aufbau der Isolationsplatte 122 ist abhängig vom Herstellungsverfahren der Gesamtelektrode 11 beziehungsweise des Bereiches der Elektrodensubeinheiten 113. Ein derartiges Herstellungsverfahren wird im folgenden beispielhaft illustriert.

Zunächst wird von der Unterseite der Isolationsplatte 122, für jede Punktelektrode 115 eine Bohrung durch die Isolationsplatte 122 bis zur späteren Position der jeweiligen Punktelektrode 115 vorgenommen, so daß am Ende jeder punktförmigen Elektrode, welche mit leitfähigem Klebstoff an der Isolationsplatte haftet, eine zugehörige Buchse zur Aufnahme eines Stifts von der Steckeinrichtung 123 geschaffen wird. Anschließend wird eine metallische Platte oder Folie aus dem gewählten Elektrodenmaterial mit den gewünschten Außendurchmesser- bzw. Dickenparametern auf eine Platte aus Isolationsmaterial mit einer Dicke entsprechend der gewünschten Dicke der Isolationsplatte 122 geklebt. Dann erfolgt ein Materialabtrag aus der metallischen Elektrodenfolie zur Bildung der Punktelektroden 115, wobei die entsprechenden Positionen der Punktelektroden über den Löchern in der Isolationsplatte angeordnet werden. Zum Materialabtrag werden kanalförmige Freiräume entsprechend dem Muster der Isolationsstege 116 (vgl. Fig. 5) ausgebildet. Dieser Materialabtrag erfolgt beispielsweise durch einen maskierten Ätzvorgang, bei dem die metallische Folie außer an den gewünschten Positionen der Punktelektroden durchgehend bis zur Isolationsplatte abgetragen wird. Anschließend werden die Kanäle zur Bildung der Isolationsstege 116 mit einem Isolationsmaterial gefüllt. Dies erfolgt beispielsweise durch Ausgießen mit einem aushärtbaren Harz.

Bei alternativen Verfahrensweisen werden mit entsprechenden Strukturierungsverfahren Buchsen in der Isolationsplatte 122 ausgebildet, die jeweils zur adaptiven Elektrode hin geschlossen und elektrisch mit der jeweiligen Punktelektrode 115 verbunden sind. In jedem Fall bildet die segmentierte Elektrode einen vakuumdichten Abschluß des Reaktionsraumes.

An der von der segmentierten Elektrode abgewandten Seite der Steckereinheiten 123 sind Platinen 124 angebracht, die Verbindungsstecker 126 zur externen Elektronik und Adress-Decoder-, Multiplex- und Demultiplex-Schaltkreise 127, 128, 129 tragen, deren Funktionen im einzelnen unten unter Bezug auf Fig. 7 erläutert wird. Bei der dargestellten Ausführungsform der Erfindung sind vier Steckereinheiten 123 (inklusive der Platinen 124) für jeweils 2 · 32 Punktelektroden 115 zu je einem MUX-Modul zur Ansteuerung von 8 · 32 Punktelektroden zusammengefaßt. Der Abstand der vier entsprechenden Platinen 124 wird durch das Rastermaß bestimmt und ist geringfügig größer als die Höhe der aufgesetzten Schaltkreise 127, 128, 129. Wiederum kann diese Dimensionierung größen- und anwendungsabhängig verändert werden. Die vier Platinen 124 sind durch z. T. leitfähige Stabilisationseinheiten 126a miteinander verbunden.

Zur vereinfachten Handhabung (Bestückung der segmentierten Elektrode mit Steckereinheiten) können an der Unterseite der Isolationsplatte 122 für jede Elektrodensubeinheit 113 eine Farbcodierung 117 vorgesehen sein. Die Platinen 124 sind derart ausgelegt, daß die in Fig. 7 illustrierten elektronischen Schaltelemente integriert werden können.

Im folgenden wird die elektrische Steuerung der erfindungsgemäßen adaptiven Elektrode 11 unter Bezug auf das Blockschaltbild gemäß Fig. 7 erläutert. Fig. 7 zeigt im Reaktionsgefäß 20 (s. Fig. 4) Punktelektroden 115 als Teil der HF-Elektrode (adaptive Elektrode 11) und die Gegenelektrode 12 (s. auch z.B. Fig. 1). Von den (insgesamt 256) Punktelektroden 115 einer Elektrodensubeinheit 113 sind vergrößert die erste und letzte Punktelektrode jeweils der ersten und vierten Platine 124 (Matrixpositionen (1,1), (2, 64) , (7,1), (8, 64) dargestellt. Ferner ist die Ringelektrode 112 dargestellt.

Der Elektronikbereich 130 umfaßt sämtliche Platinen 124 (s. Fig. 6), die den Punktelektroden 115 zugeordnet sind. Beispielhaft ist hier eine Platine 124 für 8 · 32 Punktelektroden 115 dargestellt. Der Elektronikbereich 130, der die vom Reaktionsraum abgewandte Rückseite der adaptiven Elektrode 11 darstellt, wird zur Vermeidung einer übermäßigen Druckbelastung der adaptiven Elektrode 11 mit einem Unterdruck beaufschlagt. Der Druck im Elektronikbereich 130 kann beispielsweise im Bereich von 10 bis 100 mbar liegen. Alternativ kann der Elektronikbereich zur Druckentlastung der adaptiven Elektrode auch mit einer isolierenden Flüssigkeit, wie z. B. einem Öl, ausgegossen sein, die auch eine Kühlfunktion übernehmen kann. Vom Elektronikbereich 130 getrennt sind unter atmosphärischen Bedingungen Versorgungsschaltungen 140 und eine Steuereinrichtung 150 vorgesehen. Die Versorgungsschaltungen 140 umfassen einen HF-Generator 141, eine Versorgungsspannungschaltung 142 für die Ringelektrode 12, und eine Steuerspannungschaltung 143.

Die Platine 124 besitzt für jede der Punktelektroden 115 jeweils eine Einkoppelschaltung 131. Die Einkoppelschaltung 131 ist dazu vorgesehen, jede Punktelektrode (bzw. allgemein jedes Elektrodensegment) der adaptiven Elektrode 11 gleichzeitig mit der Ausgangsspannung des HF-Generators 141 und mit einer segmentspezifischen Ausgangsspannung der Steuerspannungsschaltung 143 zu beaufschlagen. Hierbei wird erfindungsgemäß mit besonderem Vorteil die Tatsache ausgenutzt, daß die HF-Versorgung hochfrequent und die ortsselektive Erzeugung einer Feldverteilung im Reaktionsraum niederfrequent bzw. mit einem statischen elektrischen Feld erfolgt. So sind die Ausgangsparameter des HF-Generators 141 beispielsweise eine Ausgangsfrequenz im MHz-Bereich (entsprechend den üblichen Frequenzen zur Erzeugung und Aufrechterhaltung von Plasmen, z.B. 12 bis 15 MHz) und ein Spannungsbereich von ± 150 V_{SS} (sinusförmig). Hingegen erfolgt die Beaufschlagung der Punktelektroden 115 mit Steuerspannungen niederfrequent (≤ 100 Hz) oder statisch (Gleichspannung, DC). Dementsprechend enthält jede Einkoppelschaltung 131 eine Kondensator-Widerstand-Kombination (C1-C256, R1-R256), wobei die HF-Leistung über alle Kondensatoren gemeinsam eingekoppelt wird.

Auf jeder Platine ist ferner eine Adressierungsschaltung 132 vorgesehen, die die oben genannten (s. Fig. 6) Adress-Decoder, Multiplexer- und Demultiplexer-Schaltkreise 127, 128, 129 umfaßt, die wie folgt zusammenwirken.

Der Adress-Decodier-Schaltkreis 127 wählt in Abhängigkeit von den Schaltsignalen (DEMUX CONTROL und MUX CONTROL) der Steuerschaltung 150 mit einer Schaltfrequenz von 256 kHz aus, welcher Spannungswert von der Steuerspannungschaltung 143 mit dem Multiplex-Schaltkreis 128 auf eine Zentralleitung 133 und von dieser mit dem Demultiplex-Schaltkreis 129 auf einen, wiederum vom Adress-Decodier-Schaltkreis 127 ausgewählten, Einkoppelkreis 131 gemäß einer Punktelektrode 115 geschaltet wird. Bei der dargestellten Ausführungsform liefert die Steuerspannungschaltung 143 vierundsechzig Steuerspannungswerte entsprechend auf vierundsechzig Versorgungsleitungen (vgl. auch Fig. 7). Die Steuerspannungswerte auf dem Spannungsversorgungsbus 143a unterscheiden sich beispielsweise mit Spannungsschritten von 0.625 V und überdecken den Bereich von ± 20 V (Gleichspannung). Dementsprechend trifft der Multiplex-Schaltkreis 128 eine 1:64-Auswahl zur Verbindung einer der vierundsechzig Versorgungsleitungen 143a mit der Zentralleitung 133. Bei der dargestellten Ausführungsform sind ferner 256 Einkoppelschaltkreise 131 entsprechend den 256 Punktelektroden 115 vorgesehen, so daß der Demultiplex-Schaltkreis 129 eine 256:1-Auswahl von der Zentralleitung 133 auf einen der Einkoppelschaltkreise 131 trifft.

Die zu einer Platine 124 gehörigen Punktelektroden 115 (entsprechend einer Elektrodensubeinheit) werden vorzugsweise seriell entsprechend einem bestimmten Ablaufmuster angesteuert. Dabei wird mit besonderem Vorteil eine Doppelfunktion der Einkoppelkondensatoren C1-C256 genutzt. Diese dienen nämlich nicht nur der Einkoppelung der HF-Leistung, sondern auch der Aufrechterhaltung des Elektrodenpotentials an den einzelnen Punktelektroden, solange entsprechend dem seriellen Ansteuerablauf keine Verbindung mit der Steuerspannungsschaltung 143 besteht. Da von jeder Punktelektrode 115 laufend durch Stromverluste über das Plasma ein Leistungsverlust entsteht, sind die Einkoppelkondensatoren C1-C256 zyklisch auf den gewünschten Spannungswert nachzuladen. Die Einkoppelkondensatoren sind so ausgelegt, daß bei den anwendungsabhängigen Elektrodenspannungen bzw. Verlustleistungen der Ladungsverlust am jeweiligen Einkoppelkondensator und somit der Spannungsabfall an der zugehörigen Punktelektrode während eines Ansteuerzyklus (≤ 1 %) in Bezug auf die Elektrodenspannung ist.

Die Schaltfrequenz des Adress-Decodier-Schaltkreises 127 wird in Abhängigkeit von der Zahl der zu einer Subeinheit 113 gehörigen Punktelektroden 115, von der Frequenz der Steuerspannungsänderungen und von der Spannungskonstanz während eines Zyklus an den Punktelektroden so gewählt, daß der serielle Zyklendurchlauf durch die Subeinheit oder Segmentgruppe 113 eine wesentlich höhere Frequenz als die Niederfrequenzspannung der Steuerspannungsänderung besitzt. Dies bedeutet beispielsweise bei 256 Punktelektroden und einer angestrebten Zyklenfrequenz von rund 1 kHz (entsprechend 1.000 Nachladevorgängen pro Punktelektrode pro Sekunde) eine Schaltfrequenz von 256 kHz. Dieses schnelle Schalten zwischen den Spannungsstufen der Steuerspannungschaltung 143 erlaubt auch eine ortsselektive Modellierung des Feldverlaufs im Reaktionsraum 20 entsprechend einem Wechselfeldverhalten.

Die gesamte Steuerelektronik 140, 150 gemäß Fig. 7 ist potentialmäßig dem HF-Signal überlagert und deshalb schaltungstechnisch kapazitätsarm vom Steuerrechner, dem Netz und anderen Schnittstellen für Kühlzwecke usw. entkoppelt. Die Eingabe von Steuersignalen über die Steuereinrichtung 150 erfolgt vorzugsweise über einen Optokoppler.

Die oben beschriebene adaptive Elektrode 11 und die zugehörige Steuerelektronik können wie folgt modifiziert werden. Die Zahl, Form und Anordnung der Elektrodensegmente kann anwendungsabhängig verändert werden. Bei Realisierung einer Matrix mit Punktelektroden kann die Zusammenfassung in Segmentgruppen anwendungsabhängig verändert werden. Entsprechendes gilt für den Spannungsbereich der Steuerspannungschaltung 143 und die Größe der einstellbaren Spannungsschritte oder -stufen. Schließlich kann der Aufbau im Reaktionsgefäß (s. Fig. 4) umgekehrt werden, indem die geerdete Elektrode 12 auf der unteren und die HF-Elektrode 11 (insbesondere die adaptive Elektrode 11) auf der oberen Seite angebracht werden.

Der wichtigste Vorteil der adaptiven Elektrode 11 ist die Schaffung eines programmierbaren räumlichen stationären oder niederfrequenten elektrischen Feldverlaufes im Reaktionsraum, mit den geladenen Teilchen an bestimmten Orten festgehalten oder in bestimmter Weise bewegt werden können. Dadurch sind die zu manipulierenden Teilchen in beliebiger Weise positionierbar.

Fig. 8 zeigt eine schematische Seitenansicht von Teilen einer erfindungsgemäßen Anordnung, bei der die Plasmapartikelanordnung 50 zwischen der HF-Elektrode 11 und dem Substrat 30 mit der Verstelleinrichtung 31 einerseits und der Gegenelektrode 12 andererseits stufenförmig ausgebildet ist. Diese Form läßt sich beispielsweise durch Einsatz einer Ent- oder Umladevorrichtung gemäß Fig. 2 erzielen. Durch eine teilweise Bestrahlung der Partikel mit UV-Licht wird ein Teil der Teilchen (in Fig. 8 der linke Bereich) entladen, so daß das Gleichgewicht bei unveränderten Plasmabedingungen in einer geringen Höhe über der HF-Elektrode 11 eingestellt wird. Durch eine entsprechende Änderung der relativen Lage der Partikelanordnung 50 und/oder des Substrats 30 läßt sich eine teilweise Beschichtung des Substrats 30 erzielen, wie es im unteren Teil von Fig. 8 illustriert ist.

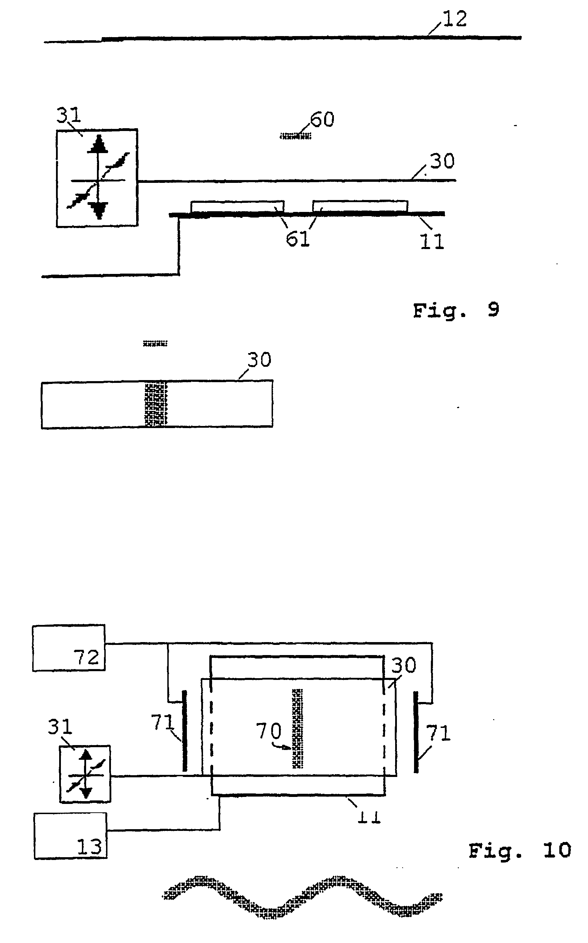

Durch eine Strukturierung der HF-Elektrode 11 mit Strukturelementen 61 gemäß Fig. 8 kann das elektrische Feld zwischen der HF-Elektrode 11 und der Gegenelektrode 12 derart beeinflußt werden, daß sich die Partikelanordnung nur in einem Bereich mit einem Potentialminimum anordnen, der sich über den Teilen der HF-Elektrode 11 befindet, die nicht von den Strukturelementen 61 bedeckt sind. Werden die Strukturelemente 61 beispielsweise durch Abdeckbalken gebildet, die einen streifenförmigen Zwischenraum lassen, so besitzt die Partikelanordnung 60 eine Streifenform (Erstreckungsrichtung senkrecht zur Zeichenebene von Fig. 9). Die Partikelanordnung 60 läßt sich wiederum erfindungsgemäß auf dem Substrat 30 ablagern.

Alternativ zu der Streifengestaltung gemäß Fig. 9 läßt sich die HF-Elektrode 11 mit beliebigen Strukturelementen 61 strukturieren oder maskieren.

Fig. 10 zeigt eine zusätzliche Möglichkeit der Ausübung äußerer Verstellkräfte auf die Partikelanordnung. Die schematische Draufsicht auf eine erfindungsgemäße Anordnung zeigt die HF-Elektrode 11 mit der Steuereinrichtung 13 und das Substrat 30 mit der Verstelieinrichtung 31. Die HF-Elektrode 11 trägt Strukturelemente (nicht dargestellt) gemäß Fig. 10, so daß sich eine streifenförmige Partikelanordnung ausbildet. Die Gestalt der Partikelanordnung 70 läßt sich weiter verändern, indem Ablenkelektroden 71 synchron mit einer Wechselspannung beaufschlagt werden. Die Ablenkelektroden 71 sind zu einer lateralen Auslenkung einer schichtförmigen Partikelanordnung in der Schichtebene eingerichtet. So läßt sich beispielsweise eine schlangenförmige Schwingung der Teilchen erzielen, wie sie im unteren Teil von Fig. 10 skizziert ist. Diese Anordnung kann wiederum auf dem Substrat 30 aufgetragen werden.

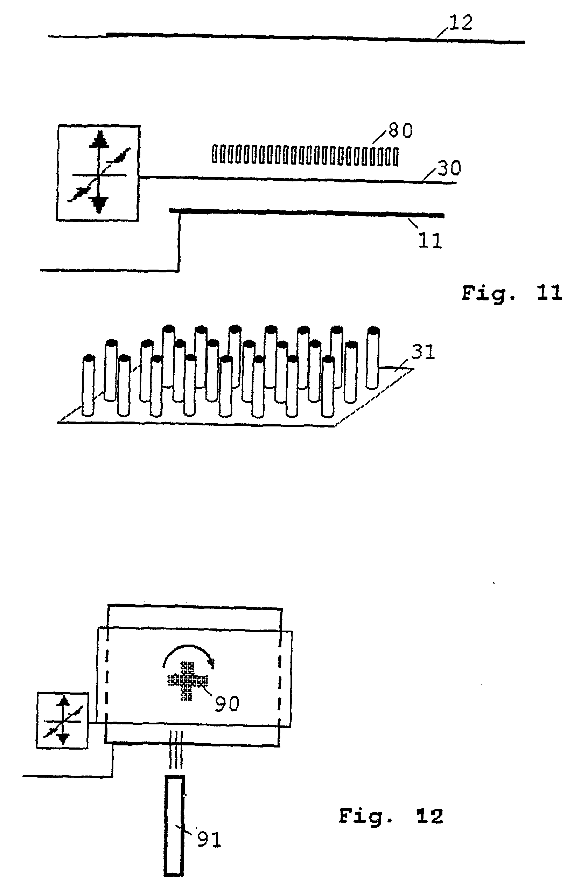

In Fig. 11 ist eine Oberflächenbeschichtung mit langgestreckten Partikeln gezeigt, die insbesondere zur Erzielung aniosotroper optischer Oberflächeneigenschaften eingerichtet ist. Die langgestreckten Teilchen sind beispielsweise sogenannte Bucky-Tubes (mikroskopische, rohrförmige Teilchen bestehend aus einer regelmäßigen Anordnung von Kohlenstoffatomen). Die Bucky-Tubes können beispielsweise eine Länge von einigen Mikrometern und einen Durchmessern von rund 10 bis 20 nm besitzen. Diese Teilchen besitzen eine verhältnismäßig große Oberfläche, die zu einer starken Aufladung im Plasma und zu einer Polarisation führt. Durch eine durch energetische Bestrahlung induzierte Entladung erfolgt eine entsprechende Annäherung an das Substrat 30 und die Adsorption der langgestreckten Teilchen mit einer vertikalen Vorzugsrichtung, wie es im unteren Teil von Fig. 11 illustriert ist. Diese Adsorbate können gegebenenfalls in einem Zusatzschritt in ihrer Lage durch eine Zusatzbeschichtung fixiert werden.

Gemäß Fig. 12, die eine Draufsicht auf Teile einer erfindungsgemäßen Anordnung zeigt, ist eine Manipulierung der Partikelanordnung 90 auch durch Ausübung eines Strahlungsdrucks von einer äußeren Lichtquelle 91 möglich. Die äußere Steuerlichtquelle kann beispielsweise durch einen Helium-Neon-Laser mit einer Leistung von rund 10 mW gebildet werden. Der mit dem Laserstrahl auf die Partikel ausgeübte Strahlungsdruck erlaubt eine präzise Positionskontrolle, die mit einer Beobachtungseinrichtung 17 (s. Fig. 1) überwacht werden kann. Mit Hilfe des Strahlungsdrucks lassen sich Partikelanordnungen vorzugsweise drehen (siehe Pfeil), oder auch auf ein seitlich angeordnetes Substrat bewegen.

Neben den illustrierten Ausführungsformen der Erfindung sind weitere Modifizierungen der erfindungsgemäßen Anordnung durch Einrichtung von Mitteln denkbar, mit denen durch Ausübung äußerer Kräfte die Bedingungen der Partikelanordnungen ortsselektiv verändert werden können. Beispielsweise ist es möglich, zusätzlich eine Magnetfeldeinrichtung zur gezielten Steuerung des Plasmas beispielsweise durch eine senkrecht zu den Elektrodenebenen ausgerichtete Magnetfeldrichtung zu erzielen. Es ist ferner möglich, das Beschichtungsverfahren dynamisch durchzuführen, wobei kontinuierlich Teilchen dem Plasmaraum zugeführt und ortsselektiv auf die Substratoberfläche aufgetragen werden. Weitere Modifizierungen beziehen sich auf das Substrat. Das Substrat muß nicht eben sein, sondern kann eine gekrümmte Oberflächen aufweisen. Es können mehrere Substrate vorhanden sein.

Es ist auch möglich, eine erfindungsgemäße Vorrichtung ohne Auftragung auf einem Substrat als Anzeigevorrichtung zu betreiben, bei der anisotrope Teilchen zur Anzeige vorbestimmter Muster zwischen verschiedenen Ausrichtungen umstellbar sind, die beispielsweise jeweils einen Zustand "Schwärzung" oder "Transparenz" repräsentieren. Es ist auch möglich, verschieden große Teilchen in verschiedenen Höhen eines Plasmas zu manipulieren und seitlich mit Anregungslichtquellen verschiedener Wellenlängen zu beleuchten, so daß farbige Anzeigen hoher Auflösung aufgebaut werden können.

Ein besonderer Vorteil der Erfindung besteht darin, daß sie durch eine unaufwendige Modifizierung herkömmlicher Plasmareaktoren (z.B. aus der Schaltkreis-Herstellung) realisiert werden kann, dessen Betriebsbedingungen gut bekannt und steuerbar sind. Die Erfindung ist zur Herstellung von sogenannten Designermaterialien mit besonderen Oberflächeneigenschaften verwendbar.

### Zweite Ausführungsform

Die zweite Ausführungsform unterscheidet sich von der oben beschriebenen ersten Ausführungsform lediglich dadurch, daß die Partikel nicht extern über einen Dispenser oder dgl. in den Reaktionsraum geliefert werden, sondern in diesem durch Aggregationsvorgänge im Reaktionsgas entstehen. Hierzu zählt beispielsweise die oben erwähnte Partikelbildung in silanhaltigen Reaktionsgasen bei der CVD-Abscheidung von amorphen Siliziumschichten. Es sind jedoch entsprechende Anwendungen bei allen anderen CVD-Abscheideverfahren, insbesondere von Halbleitern, möglich.

Erfindungsgemäß werden Partikel, die während der Plasmaabscheidung im Reaktionsgas entstehen, mit den gleichen Mitteln manipuliert, wie dies oben unter Bezug auf die erste Ausführungsform beschrieben wurde. Es ist insbesondere vorgesehen, durch eine ortsselektive, energiereiche Bestrahlung die Partikel in vorbestimmten Teilbereichen ihrer Entstehung zu entladen oder umzuladen. Die Teilbereiche entsprechen bestimmten Depositionsmustern, nach denen die Partikel in die auf einem Substrat im Reaktionsgefäß aufwachsende Schicht eingebettet werden sollen. Die Depositionsmuster sind zur Erzielung der gewünschten optischen oder photoelektrischen Eigenschaften der abgeschiedenen Schicht ausgewählt. Charakteristische Dimensionen der Depositionsmuster -reichen von der Auflösungsgrenze der jeweils gewählten energiereichen Bestrahlung (nm-Bereich) bis zu den Größendimensionen der Plasmaelektroden. Die ortsselektive Deposition simultan zur Schichtabscheidung erfolgt dadurch, daß die Partikel durch das Ent- oder Umladen im Kräftegleichgewicht der Felder im Reaktionsraum gestört werden und damit auf das Substrat absinken können. Falls nicht, wie oben beschrieben ein zusätzliches, statisches elektrisches Feld zur Herstellung des Kräftegleichgewichts vorgesehen ist, erlaubt der Ent- oder Umladevorgang an den Partikeln, daß diese die Raumladungszone in Elektroden- bzw. Substratnähe, die die negativ geladenen Partikel abschirmen würde, durchlaufen können.

Gegenstand der Erfindung ist somit auch eine amorphe Halbleiterbeschichtung mit eingebetteten Partikeln, wobei die Partikel entsprechend einem vorbestimmten Depositionsmuster auf bestimmte Teilbereiche der Schicht beschränkt sind. Die Depositionsmuster umfassen sowohl die laterale -Partikelverteilung in der Schichtebene als auch bei zeitabhängiger Änderung der ortsselektiven Ent- oder Umladevorgänge an den Partikeln im Reaktionsgas eine Partikelverteilung senkrecht zur Schichtebene. Es lassen sich somit beliebige Raumverteilungen von Partikeln in Schichten erzeugen, die durch Plasmabscheidung hergestellt sind.

Bei der zweiten Ausführungsform ist es insbesondere auch möglich, die Partikel im Reaktionsgas vor der Abscheidung zu bearbeiten, wie dies oben unter Bezug auf die erste Ausführungsform beschrieben wurde. Es ist möglich, die Partikel unter Einwirkung elektrischer Steuerfelder und der energiereichen Bestrahlung zur Ent- oder Umladung in einen Plasmabereich zu überführen, in dem ein Abtrag von der Oberfläche der Partikel oder eine Beschichtung der Partikel mit einem zusätzlichen Material erfolgt, wobei die Deposition in der Schicht auf dem Substrat nach diesem Bearbeitungsschritt folgt.

## Patentansprüche

1. Verfahren zur Manipulierung von Partikeln (10, 40, 50, 60, 80, 90), die in einem Plasma eines Träger- oder Reaktionsgases verteilt sind,
wobei
zwischen den Partikeln eine derart geringe Coulomb-Wechselwirkung gegeben ist, dass die Partikel keinen plamakristallinen Zustand bilden, und
eine ortsselektive Einwirkung äußerer Verstellkräfte auf die Partikel und/oder eine ortsselektive Änderung der Plasmabedingungen erfolgt, um mindestens einen Teil der Partikel maskenfrei auf eine Substratoberfläche aufzutragen und/oder einer ortsselektiven Plasmabehandlung im Träger- oder Reaktionsgas zu unterziehen.

2. Verfahren gemäß Anspruch 1, bei dem der Abstand der Partikel von der Substratoberfläche durch eine Bewegung der Substratoberfläche, die Einwirkung äußerer Verstellkräfte und/oder die Änderung der Plasmabedingungen geändert wird, bis die Partikel mindestens teilweise auf der Substratoberfläche anhaften.

3. Verfahren gemäß einem der Ansprüche 1 bis 2, bei dem die äußeren Verstallkräfte ortsselektiv durch eine Teilchenentladung, eine Teilchenumladung oder einen Licht-Strahlungsdruck bewirkt werden.

4. Verfahren gemäß Anspruch 3, bei dem die Teilchenentladung oder Teilchenumladung durch eine ortsselektive UV- oder Elektronenbestrahlung oder eine Laserumladung der Partikel erfolgt.

5. Verfahren gemäß einem der Ansprüche 1 bis 4, bei dem die Änderung der Plasmabedingungen eine Änderung des Plasmadrucks, der Plasmatemperatur, des Trägergases, der Plasmaenergie und/oder der Betriebsfrequenz des Plasmas, ein Abschalten der Plasmaerzeugung und/oder eine Feldbeeinflussung von elektrischen Feldern im Bereich der Partikel umfaßt.

6. Verfahren gemäß Anspruch 5, bei dem die Feldbeeinflussung die Einstellung eines statischen oder niederfrequent veränderlichen elektrischen Feldes derart umfaßt, daß sich die Partikel entlang einer dorbestimmten gekrümmten Fläche oder in einem in vorbestimmter Weise abgegrenzten Bereich anordnen oder niederfrequent bewegen.

7. Verfahren gemäß einem der vorhergehenden Ansprüche, bei dem die Partikel (80) eine längliche, stabförmige Gestalt besitzen und so auf der Substratoberfläche aufgetragen werden, daß sich die stabförmige Gestalt im wesentlichen senkrecht von der Substratoberfläche erstreckt.

8. Verfahren gemäß einem der vorhergehenden Ansprüche, bei dem die Partikel im Reaktionsgas gebildet oder extern in das Plasma eingeführt werden.

9. Verfahren, bei dem, während mit einem Plasma-CVD-Abscheideverfahrens auf einem Substrat aus einem Reaktionsgas eine Beschichtung erfolgt, im Reaktionsgas gebildete Partikel nach einem Verfahren gemäß einem der vorhergehenden Ansprüche manipuliert werden und/oder simultan in der Beschichtung eingebettet werden.

10. Verfahren gemäß Anspruch 9, bei dem nanokristalline Halbleiterpartikel entsprechend einem vorbestimmten Depositionsmuster in eine Halbleiterschicht eingebettet werden.

11. Verfahren gemäß Anspruch 10, bei dem die Halbleiterschicht mit den eingebetteten nanokristallinen Halbleiterpartikeln Teil einer photovoltaischen Einrichtung ist.

12. Verfahren gemäß einem der vorhergehenden Ansprüche, bei dem die Partikel charakteristische Größen von wenigen Nanometern bis 10 nm besitzen.

13. Vorrichtung zur Manipulierung von Partikeln (10, 40, 50, 60, 80, 90) im Plasma eines Träger- oder Reaktionsgases mit einem Reaktionsgefäß, in dem Mittel zur Plasmaausbildung mit einer Hochfrequenzelektrode (11) und einer Gegenelektrode (12) vorgesehen sind, wobei
die Hochfrequenzelektrode (11) und die Gegenelektrode (12) zur Ausbildung von Plasmabedingungen im Reaktionsgefäß derart eingerichtet sind, dass zwischen den Partikeln eine so geringe Coulomb-Wechselwirkung gegeben ist, dass die Partikel keinen plasmakristallinen Zustand bilden, und
im Reaktionsgefäß enthalten sind:
- ein Substrat (30) zur Abscheidung von mindestens einem Teil der Partikel,
- feldformende Strukturen (11, 41) zur ortsselektiven Manipulierung der Partikel, Mittel zur ortsselektiven Teilchenänderung oder Umladung und/oder Mittel zur Ausübung eines Strahlungsdruckes, und
- Beobachtungsmittel und/oder Steuermittel.

14. Vorrichtung gemäß Anspruch 13, bei dem die Mittel zur Plasmaausbildung flächige, im wesentlichen parallele Plasmaelektroden (11, 12) sind, die zur Ausbildung einer Gas- oder Glimmentladung im Trägergas eingerichtet sind und zwischen denen das Substrat beweglich angeordnet ist.

15. Vorrichtung gemäß Anspruch 13, bei der die feldformenden Strukturen als Teil der Hochfrequenzelektrode (11) eine Elektrodeneinrichtung mit einer Vielzahl von Elektrodensegmenten umfassen, die dazu eingerichtet sind, gemeinsam mit einer Hochfrequenzspannung und jeweils einzeln mit einer spezifischen Gleichspannung oder Niederfrequenzspannung beaufschlagt werden.

16. Vorrichtung gemäß Anspruch 15, bei der jedes Elektrodensegment mit einer Einkoppelschaltung verbunden ist, die jeweils einen Einkoppei- und Ladekondensator (C1, ..., C256) enthält, der simultan zur Einkopplung der Hochfrequenzspannung von einem Hochfrequenzgenerator (141) und zur Aufladung entsprechend einer vorbestimmten Ausgangsspannung einer Steuerspannungsschaltung (143) eingerichtet ist.

17. Vorrichtung gemäß Anspruch 15 oder 16, bei der die Elektrodensegmente matrixartig reihen- und spaltenweise in einer Ebene angeordnet sind.

18. Vorrichtung gemäß einem der Ansprüche 16 bis 17, bei der die Elektrodensegmente Punktelektroden (115) umfassen, deren Elektrodenflächen wesentlich kleiner als die Gesamtfläche der Hochfrequenzelektrodeneinrichtung ist.

19. Vorrichtung gemäß einem der Ansprüche 15 bis 18, bei der die Elektrodensegmente (115) zu Elektrodensubeinheiten (113) zusammengefaßt sind.

20. Vorrichtung gemäß einem der Ansprüche 15 bis 19, bei der die Elektrodensegmente (115) mit einer Isolationsplatte (122) vorgesehen sind, deren Vorderseite zu einem Reaktionsgefäß zur Ausbildung eines Plasmas weist und für jedes Elektrodensegment eine Buchse aufweist, wobei die Buchsen zur Aufnahme von Steckeinheiten (123) eingerichtet sind.

21. Vorrichtung gemäß Anspruch 20, bei der jede Steckeinheit (123) eine Platine (124) mit Einkoppel- und Steuerschaltkreisen (131, 127, 128, 129) trägt.

22. Hochfrequenzelektrodeneinrichtung gemäß Anspruch 21, bei der die Platinen (124) in einem Raum angeordnet sind, der mit einem Unterdruck beaufschlagt ist.

23. Vorrichtung gemäß Anspruch 21, bei der die Platinen (124) in einem Raum angeordnet sind, der mit einer isolierenden Flüssigkeit gefüllt ist.

24. Vorrichtung gemäß einem der Ansprüche 19 bis 22, bei der die Elektrodensubeinheiten (113) jeweils mit einer Kombination aus einem Multiplexschaltkreis (129) und einem Demultiplexschaltkreis (128) verbunden sind, wobei der Multiplexschaltkreis (129) in Abhängigkeit von Steuersignalen eine Verbindung zwischen einer von einer Vielzahl von Ausgangsspannungen einer Steuerspannungsschaltung (143) und dem Eingang des Demultiplex-Schaltkreises (128) herstellt und dieser die ausgewählte Ausgangsspannung an eine der Elektrodensegmente (115) der jeweiligen Elektrodensubeinheit (113) gibt.

25. Vorrichtung gemäß Anspruch 24, bei der die Elektrodensegmente (113) sequentiell mit Ausgangsspannungen der Steuerspannungsschaltung (143) beaufschlagt sind.

## Claims

1. Method of manipulating particles (10, 40, 50, 60, 80, 90) which are dispersed in a plasma of a carrier or reaction gas,
wherein there is such a low Coulomb interaction between the particles that the particles do not form any plasma-crystalline state and
at selected locations external displacement forces act on the particles and/or there is an alteration of the plasma conditions in order to deposit at least some of the particles without any mask on a substrate surface and/or subject them at selected locations to plasma treatment in the carrier or reaction gas.

2. Method according to claim 1, in which the spacing of the particles from the substrate surface is altered by a movement of the substrate surface, the action of external displacement forces and/or the alteration of the plasma conditions until the particles adhere at least partially to the substrate surface.

3. Method according to one of claims 1 to 2, in which the external displacement forces are caused at selected locations by particle discharge, particle charge reversal or light radiation pressure.

4. Method according to claim 3, in which the particle discharge or particle charge reversal takes place through UV or electron irradiation at selected locations or through laser charge reversal of the particles.

5. Method according to one of claims 1 to 4, in which the alteration of the plasma conditions comprises an alteration in the plasma pressure, the plasma temperature, the carrier gas, the plasma energy and/or the operating frequency of the plasma, switching off the plasma generation system and/or influencing the electrical fields in the region of the particles.

6. Method according to claim 5, in which field-influencing comprises setting a static or low-frequency variable electrical field, in such a way that the particles are arranged or move at a low frequency along a predetermined curved surface or in a region which has been delimited in a predetermined manner.

7. Method according to one of the preceding claims in which the particles (80) are of elongated, rod-like shape and are so deposited on the substrate surface that the rod-like shape extends substantially vertically from the substrate surface.

8. Method according to one of the preceding claims, in which the particles are formed in the reaction gas or are introduced externally into the plasma.

9. Method in which, during coating of a substrate from a reaction gas by means of a plasma CVD deposition method, particles formed in the reaction gas are manipulated using a method according to one of the preceding claims and/or are simultaneously embedded in the coating.

10. Method according to claim 10 in which nanocrystalline semiconductor particles are embedded in a semiconductor layer according to a predetermined deposition pattern.

11. Method according to claim 10, in which the semiconductor layer with the embedded nanocrystalline semiconductor particles forms part of a photovoltaic device.

12. Method according to one of the preceding claims in which the particles have characteristic sizes of between a few nanometres and 10 nm.

13. Apparatus for manipulating particles (10, 40, 50, 60, 80, 90) in the plasma of a carrier or reaction gas with a reaction vessel in which means for forming a plasma are provided with a high-frequency electrode (11) and a counter-electrode (12), wherein
the high-frequency electrode (11) and the counter-electrode (12) are so arranged for forming plasma conditions in the reaction vessel that there is such a low Coulomb interaction between the particles that the particles do not form any plasma-crystalline state, and
there are contained in the reaction vessel:
- a substrate (30) for depositing at least some of the particles,
- field-shaping structures (11, 41) for manipulating the particles at selected locations, means for particle alteration or charge reversal at selected locations and/or means for exerting radiation pressure, and
- observation means and/or control means.

14. Apparatus according to claim 13, in which the means for forming plasma are flat, substantially parallel plasma electrodes (11, 12) which are arranged to form a gas discharge or glow discharge in the carrier gas, and the substrate is arranged so as to be moveable between said electrodes.

15. Apparatus according to claim 13, in which the field-shaping structures include as part of the high-frequency electrode (11) an electrode device with a plurality of electrode segments which are arranged to have applied to them jointly a high-frequency voltage and to have applied to them each individually a specific direct-current voltage or low-frequency voltage.

16. Apparatus according to claim 15, in which each electrode segment is connected to a coupling circuit which in each case contains a coupling and charging capacitor (C1, ..., C256), which is arranged simultaneously for connecting the high-frequency voltage from a high-frequency generator (141) and for charging according to a predetermined output voltage of a control voltage circuit (143).

17. Apparatus according to claim 15 or 16, in which the electrode segments are arranged like a matrix in rows and columns in one plane.

18. Apparatus according to one of claims 16 to 17, in which the electrode segments comprise point electrodes (115), the electrode surfaces of which are substantially smaller than the total surface of the high-frequency electrode device.

19. Apparatus according to one of claims 15 to 18, in which the electrode segments (115) are combined to form electrode subunits (113).

20. Device according to one of claims 15 to 19, in which the electrode segments (115) are provided with an insulating plate (122), the front side of which points towards a reaction vessel for forming a plasma and has a socket for each electrode segment, the sockets being arranged to receive plug-in units (123).

21. Apparatus according to claim 20, in which each plug-in unit (123) carries a board (124) with coupling and control circuits (131, 127, 128, 129).

22. High-frequency electrode device according to claim 21, in which the boards (124) are arranged in a chamber to which negative pressure is applied.

23. Apparatus according to claim 21, in which the boards (124) are arranged in a chamber which is filled with an insulating liquid.

24. Apparatus according to one of claims 19 to 22, in which the electrode subunits (113) are in each case connected to a combination of a multiplex circuit (129) and a demultiplex circuit (128), the multiplex circuit (129) producing, in dependence on control signals, a connection between one of a plurality of output voltages of a control voltage circuit (143) and the input of the demultiplex circuit (128), and the latter passing the selected output voltage to one of the electrode segments (115) of the respective electrode subunit (113).

25. Apparatus according to claim 24, in which output voltages of the control voltage circuit (143) are applied sequentially to the electrode segments (113).

## Revendications

1. Procédé pour la manipulation de particules (10, 40, 50, 60, 80, 90) qui sont réparties dans un plasma d'un gaz porteur ou de réaction, **caractérisé en ce qu'**il existe entre les particules un effet interactif de Coulomb tellement faible que les particules ne forment pas d'état plasma cristallin et **en ce que**, pour appliquer au moins une partie des particules sans masque sur une surface de substrat et/ou pour les soustraire à un traitement au plasma localement sélectif dans le gaz porteur ou de réaction, il se produit un effet localement sélectif d'efforts de déplacement extérieurs sur les particules et/ou une modification localement sélective des conditions du plasma.

2. Procédé selon la revendication 1, **caractérisé en ce que** l'espacement des particules par rapport à la surface du substrat est modifié par un mouvement de la surface du substrat, par l'action d'efforts de déplacement extérieurs et/ou par la modification des conditions du plasma, et ceci jusqu'à ce que les particules adhèrent au moins partiellement sur la surface du substrat.

3. Procédé selon l'une des revendications 1 à 2, **caractérisé en ce que** les efforts extérieurs de déplacement sont produits d'une manière localement sélective par une décharge de particules, par une inversion de charge des particules ou par une pression de rayonnement lumineux.

4. Procédé selon la revendication 3, **caractérisé en ce que** la décharge de particules ou l'inversion de charge des particules a lieu à l'aide d'un rayonnement UV ou d'électrons localement sélectif ou à l'aide d'une inversion de charge par laser des particules.

5. Procédé selon l'une des revendications 1 à 4, **caractérisé en ce que** la modification des conditions du plasma comprend une modification de la pression du plasma, de la température du plasma, du gaz porteur, de l'énergie du plasma et/ou de la fréquence de mise en oeuvre du plasma, un arrêt de la production du plasma et/ou une influence exercée sur les champs électriques dans la zone des particules.

6. Procédé selon la revendication 5, **caractérisé en ce que** l'influence exercée sur les champs agit de telle manière sur la constitution d'un champ électrique statique ou variable à basse fréquence que les particules se placent le long d'une surface courbe prédéterminée ou dans une zone délimitée d'une manière prédéterminée ou se déplacent à basse fréquence.

7. Procédé selon l'une des revendications précédentes, **caractérisé en ce que** les particules (80) ont une configuration oblongue en forme de barre et sont appliquées de telle manière sur la surface du substrat que la configuration en forme de barre s'étend sensiblement perpendiculairement à partir de la surface du substrat.

8. Procédé selon l'une des revendications précédentes, **caractérisé en ce que** les particules sont formées dans le gaz de réaction ou sont introduites en externe dans le plasma.

9. Procédé **caractérisé en ce que**, alors qu'un revêtement est appliqué sur un substrat se composant d'un gaz de réaction par un procédé de séparation CVD au plasma, des particules formées dans le gaz de réaction sont manipulées avec un procédé selon l'une des revendications précédentes et/ou sont enrobées simultanément dans le revêtement.

10. Procédé selon la revendication 9, **caractérisé en ce que** des particules de semi-conducteurs nanocristallins sont enrobées dans une couche de semi-conducteurs selon un modèle de déposition prédéterminé.

11. Procédé selon la revendication 10, **caractérisé en ce que** la couche de semi-conducteurs avec les particules de semi-conducteurs nanocristallins enrobés est une partie d'un dispositif photovoltaïque.

12. Procédé selon l'une des revendications précédentes, **caractérisé en ce que** les particules ont des tailles caractéristiques de quelques nanomètres jusqu'à 10 nm.

13. Dispositif pour manipuler des particules (10, 40, 50, 60, 80, 90) dans le plasma d'un gaz porteur où de réaction avec un réacteur dans lequel sont prévus des moyens pour la formation du plasma avec une électrode à haute fréquence (11) et une contre-électrode (12), **caractérisé en ce que**, pour la formation de conditions pour le plasma, l'électrode à haute fréquence (11) et la contre-électrode (12) sont disposées de telle façon dans le réacteur qu'entre les particules se produit un effet interactif de Coulomb tellement faible que les particules ne forment pas d'état plasma cristallin et **en ce que** dans le réacteur sont contenus :
- un substrat (30) pour la séparation d'au moins une partie des particules,
- des structures formant les champs (11, 41) pour une manipulation localement sélective des particules, des moyens pour une modification ou une inversion de charge localement sélective des particules et/ou des moyens pour exercer une pression de rayonnement lumineux et
- des moyens d'observation et/ou des moyens de commande.

14. Dispositif selon la revendication 13, **caractérisé en ce que** les moyens pour la formation du plasma sont des électrodes à plasma plates et sensiblement parallèles (11, 12), qui sont prévues pour la formation d'une décharge gazeuse ou lumineuse dans le gaz porteur et entre lesquelles le substrat est disposé de manière mobile.

15. Dispositif selon la revendication 13, **caractérisé en ce qu'**en tant que partie constituante de l'électrode à haute fréquence (11), les structures formant les champs comprennent un dispositif d'électrodes avec une pluralité de segments d'électrodes, qui sont équipés pour recevoir ensemble une tension à haute fréquence et respectivement individuellement une tension continue spécifique ou une tension à basse fréquence spécifique.

16. Dispositif selon la revendication 15, **caractérisé en ce que** chaque segment d'électrode est relié avec un circuit de couplage en alimentation comprenant respectivement un condensateur de couplage en alimentation et de charge (C1, ..., C256), qui est équipé simultanément pour le couplage en alimentation de la tension à haute fréquence à partir d'un générateur à haute fréquence (141) et pour être chargé par une tension de sortie prédéterminée correspondante d'un circuit de tension de commande (143).

17. Dispositif selon la revendication 15 ou 16, **caractérisé en ce que** les segments d'électrodes sont disposés à la manière d'une matrice par séries et par colonnes sur un même plan.

18. Dispositif selon l'une des revendications 16 à 17, **caractérisé en ce que** les segments d'électrodes comprennent des électrodes ponctuelles (115), dont les surfaces d'électrodes sont nettement moins importantes que la surface d'ensemble du dispositif d'électrodes à haute fréquence.

19. Dispositif selon l'une des revendications 15 à 18, **caractérisé en ce que** les segments d'électrodes (115) sont rassemblés pour former des sous-unités d'électrodes (113).

20. Dispositif selon l'une des revendications 15 à 19, **caractérisé en ce que** les segments d'électrodes (115) sont munis d'une plaque d'isolation (122), dont le côté avant est dirigé vers un réacteur pour la formation d'un plasma et comprend une douille pour chaque segment d'électrode, les douilles étant prévues pour recevoir des unités d'enfichage (123).

21. Dispositif selon la revendication 20, **caractérisé en ce que** chaque unité d'enfichage (123) porte une platine (124) comprenant des circuits le couplage en alimentation et de commande (131, 127, 128, 129).

22. Installation d'électrodes à haute fréquence selon la revendication 21, **caractérisé en ce que** les platines (124) sont disposées dans un compartiment soumis à une dépression.

23. Dispositif selon la revendication 21, **caractérisé en ce que** les platines (124) sont disposées dans un compartiment rempli d'un liquide isolant.

24. Dispositif selon l'une des revendications 19 à 22, **caractérisé en ce que** les sous-unités d'électrodes (113) sont reliées respectivement à une combinaison se composant d'un circuit de multiplexage (129) et d'un circuit de démultiplexage (128), le circuit de multiplexage (129) réalisant, en fonction de signaux de commande, une liaison entre une de la pluralité des tensions de sortie d'un circuit de tensions de sortie (143) et l'entrée du circuit de démultiplexage (128) et celui-ci appliquant la tension de sortie sélectionnée à l'un des segments d'électrodes (115) de la sous-unité d'électrode respective (113).

25. Dispositif selon la revendication 24, **caractérisé en ce que** les segments d'électrodes (113) sont soumis d'une manière séquentielle à des tensions de sortie du circuit de tension de commande (143).
